(19) Europäisches Patentamt
European Patent Office
Office européen des brevets

(11) EP 2 538 417 A1

(12) **EUROPEAN PATENT APPLICATION**
published in accordance with Art. 153(4) EPC

(43) Date of publication:
**26.12.2012 Bulletin 2012/52**

(21) Application number: **11744487.7**

(22) Date of filing: **26.01.2011**

(51) Int Cl.:
***H01B 5/14*** *(2006.01)* ***B32B 9/00*** *(2006.01)*
***C23C 14/08*** *(2006.01)* ***C23C 14/48*** *(2006.01)*
***H01B 13/00*** *(2006.01)*

(86) International application number:
**PCT/JP2011/051507**

(87) International publication number:
**WO 2011/102198 (25.08.2011 Gazette 2011/34)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **19.02.2010 JP 2010035450**

(71) Applicant: **LINTEC Corporation**
**Tokyo 173-0001 (JP)**

(72) Inventors:
- **NAGAMOTO, Koichi**
  **Tokyo 173-0001 (JP)**
- **KONDO, Takeshi**
  **Tokyo 173-0001 (JP)**
- **SUZUKI, Yuta**
  **Tokyo 173-0001 (JP)**
- **NAGANAWA, Satoshi**
  **Tokyo 173-0001 (JP)**

(74) Representative: **Strehl Schübel-Hopf & Partner**
**Maximilianstrasse 54**
**80538 München (DE)**

# (54) TRANSPARENT CONDUCTIVE FILM, PROCESS FOR PRODUCING SAME, AND ELECTRONIC DEVICE EMPLOYING TRANSPARENT CONDUCTIVE FILM

(57) The present invention enables provision of a transparent conductive film which exhibits excellent gas barrier performance and electrical conductivity and which exhibits low sheet resistivity and high electrical conductivity, even after having been placed in moist and high-temperature conditions.

The conductive film of the present invention is in the form of a zinc oxide-based electrically conductive stacked structure, and the film includes a substrate and, formed on at least one surface of the substrate, (A) a gas barrier layer and (B) a transparent conductive layer formed of a zinc oxide-based conductive material, wherein the gas barrier layer is formed of a material containing at least oxygen atoms, carbon atoms, and silicon atoms, and includes a region in which the oxygen atom concentration gradually decreases and the carbon atom concentration gradually increases from the surface in the depth direction of the layer.

FIG. 3

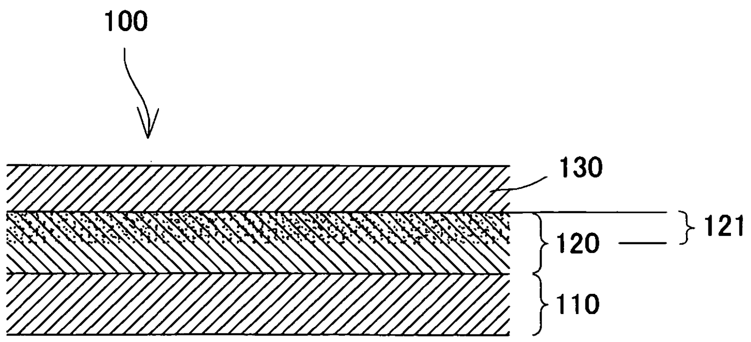


EP 2 538 417 A1

## Description

### Technical Field

The present invention relates to a transparent conductive film which exhibits excellent gas barrier performance and transparency as well as electrical conductivity, to a production method therefor, and to an electronic device employing the transparent conductive film.

### Background Art

In recent years, for the purpose of realizing reduction in thickness and weight, flexibility, etc., attempts have been made to replace of a glass plate with a transparent plastic film serving as a substrate for display devices such as a liquid crystal display and an electroluminescence (EL) display. However, since plastic film is more permeable by water vapor, oxygen, or the like than glass plate, elements in a display device tend to be damaged, which is problematic.

In order to overcome the drawback, there has been proposed a flexible display substrate formed of a transparent plastic film on which a transparent gas barrier layer made of metal oxide is formed (see Patent Document 1).

However, the flexible display substrate disclosed in Patent Document 1 is produced by stacking a metal oxide transparent gas barrier layer on a transparent plastic film through vapor deposition, ion plating, sputtering, or a similar technique. Therefore, when the substrate is wound or bent, cracking occurs in the gas barrier layer, and gas barrier performance is problematically degraded.

There has been proposed another gas barrier stacked structure which is formed of a plastic film, and a resin layer predominantly containing polyorganosilsesquioxane on at least one surface of the plastic film (see Patent Document 2).

However, in order to attain the gas barrier performance to oxygen, water vapor, or the like of the gas barrier performance stacked structure disclosed in Patent Document 2, an additional inorganic compound layer must be further stacked. Such an additional process includes a cumbersome step, is high cost, and may employ toxic gas, which are problematic.

Meanwhile, in a transparent conductive film employing a transparent plastic substrate, ITO (tin-doped indium oxide) is used as a transparent conductive material. Since ITO contains indium, which is a rare metal, in recent years, a zinc oxide-based conductive material has been proposed as an ITO conductive material substitute. However, the sheet resistivity of a zinc oxide-based conductive material under moist and high-temperature conditions deteriorates more as compared with the case of ITO, which is also problematic.

Thus, one proposed means for solving the problem is a transparent conductive material having a plastic substrate sequentially coated with a hard coat layer and silicon-doped zinc oxide film (see Patent Document 3). Such a transparent conductive material, which has a silicon-doped zinc oxide film mitigates variation over time of sheet resistivity under high-temperature and high-moisture conditions. However, crystallinity is degraded, to thereby problematically impair electrical conductivity.

There has also been proposed a transparent heating element having a transparent conductive layer whose heat resistance has been enhanced by adding gallium oxide thereto (Patent Document 4). However, such a transparent heating element must contain gallium oxide under the specified condition, which problematically limits production conditions.

There has also been proposed a heat resistance has been improved by forming a heat-resistant layer having higher oxidation degree on a transparent conductive layer (Patent Document 5). Patent Document 5 discloses heat resistance but fails to disclose behavior under high-moisture conditions. That is, there has not been realized control of sheet resistivity under high-temperature and high-moisture conditions.

Alternatively, there has been disclosed enhancement of water-vapor-barrier performance by coating a transparent conductive layer with an overcoat layer predominantly containing polyolefin (Patent Document 6). In another case, attempts have been made to control sheet resistivity under high-temperature conditions by stacking a heat-resistant electrically conductive layer on a gallium oxide-zinc oxide transparent conductive material.

In a gallium oxide-zinc oxide transparent conductive layer, sheet resistivity under moisture and high temperature conditions has been controlled by considerably increasing the amount of gallium oxide (dopant) and adjusting the thickness to 1,000 nm (Non-Patent Document 1). However, when the thickness of the transparent conductive layer is increased to 1,000 nm, productivity is impaired considerably. In addition, when the amount of gallium oxide (dopant) increases greatly, raw material cost increases, which is not practical.

Prior Arts Documents

Patent Documents

Patent Document 1: Japanese Patent Application Laid-Open *(kokai)* No. 2000-338901
Patent Document 2: Japanese Patent Application Laid-Open (*kokai*) No. 2006-123307
Patent Document 3: Japanese Patent Application Laid-Open *(kokai)* No. Hei 8-45452
Patent Document 4: Japanese Patent Application Laid-Open *(kokai)* No. Hei 6-187833
Patent Document 5: Japanese Patent Application Laid-Open *(kokai)* No. 2009-199812
Patent Document 6: Japanese Patent Application Laid-Open *(kokai)* No. 2009-110897

Non-Patent Documents

Non-Patent Document 1: APPLIED PHYSICS LETTERS 89, 091904 (2006)

Summary of the Invention

Problems to be Solved by the Invention

The present invention has been conceived in order to overcome the aforementioned drawbacks. Thus, an object of the present invention is to provide a transparent conductive film which exhibits excellent gas barrier performance and transparency/electrical conductivity and which exhibits low sheet resistivity and high electrical conductivity, even after having been placed in moist and high-temperature conditions. Another object is to provide a method for producing the transparent conductive film. Still another object is to provide an electronic device employing the transparent conductive film.

Means for Solving the Problems

The present inventors have conducted extensive studies and have found that a film including a gas barrier layer which is formed of a material containing at least oxygen atoms, carbon atoms, and silicon atoms and which has a region in which the oxygen atom concentration gradually decreases and the carbon atom concentration gradually increases from the surface in the depth direction exhibits excellent gas barrier performance, transparency, and flexibility. The inventors have also found that a transparent conductive film which exhibits low sheet resistivity and high electrical conductivity, even after having been placed under moist and high-temperature conditions, can be produced through stacking a conductive layer formed from a zinc oxide-based conductive material on the above film. The present invention has been accomplished on the basis of these findings. The inventors have also found that the aforementioned gas barrier layer can be readily and effectively formed through ion implantation of a layer containing a polyorganosiloxane compound, the layer being included in a film as a surface portion.

In a first mode of the present invention, there is provided a transparent conductive film which is in the form of a zinc oxide-based electrically conductive stacked structure, characterized in that the film comprises a substrate and, formed on at least one surface of the substrate, (A) a gas barrier layer and (B) a transparent conductive layer formed of a zinc oxide-based conductive material, wherein the gas barrier layer is formed of a material containing at least oxygen atoms, carbon atoms, and silicon atoms, and includes a region in which the oxygen atom concentration gradually decreases and the carbon atom concentration gradually increases from the surface in the depth direction of the layer.

A second mode of the present invention is directed to a specific embodiment of the transparent conductive film of the first mode, wherein the surface layer part of the gas barrier layer has an oxygen atom fraction of 10 to 70%, a carbon atom fraction of 10 to 70%, and a silicon atom fraction of 5 to 35%, each atom fraction being calculated with respect to the total number of the oxygen atoms, carbon atoms, and silicon atoms contained in the gas barrier layer.

A third mode of the present invention is directed to a specific embodiment of the transparent conductive film of the first or second mode, wherein the gas barrier layer exhibits a silicon atom 2p electron binding energy peak at 102 to 104 eV, as measured through X-ray photoelectron spectrometry (XPS) of the surface layer part of the gas battier layer thereof.

A fourth mode of the present invention is directed to a specific embodiment of the transparent conductive film of any of the first to third modes, wherein the gas barrier layer contains a polyorganosiloxane compound.

A fifth mode of the present invention is directed to a specific embodiment of the transparent conductive film of the fourth mode, wherein the polyorganosiloxane compound is a polyorganosiloxane represented by the following formula (a):

[F1]

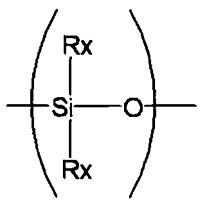

(a)

or formula (b):

[F2]

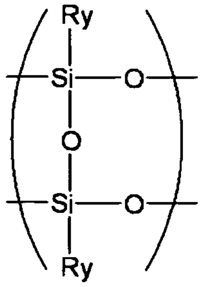

(b)

(wherein Rx and Ry each represent a non-hydrolyzable group such as a hydrogen atom, a substituted or unsubstituted alkyl group, a substituted or unsubstituted alkenyl group, or a substituted or unsubstituted aryl group; a plurality of Rxs in formula (a) may be identical to or different from one another; and a plurality of Rys in formula (b) may be identical to or different from one another, excluding the case where the two Rxs in formula (a) are hydrogen atoms).

A sixth mode of the present invention is directed to a specific embodiment of the transparent conductive film of any of the first to fifth modes, wherein the gas barrier layer has a thickness of 30 nm to 10 μm, and the surface layer part of the gas barrier layer has a thickness of 5 nm to 100 nm.

A seventh mode of the present invention is directed to a specific embodiment of the transparent conductive film of any of the first to sixth modes, wherein the gas barrier layer is formed through ion implantation into a layer containing a polyorganosiloxane compound.

An eighth mode of the present invention is directed to a specific embodiment of the transparent conductive film of the seventh mode, wherein ion implantation is performed to a surface layer part of the layer containing a polyorganosiloxane compound.

A ninth mode of the present invention is directed to a specific embodiment of the transparent conductive film of the seventh or eighth mode, wherein the ion is an ionic species formed through ionization of at least one gas selected from the group consisting of hydrogen, nitrogen, oxygen, a rare gas, and a fluorocarbon.

A tenth mode of the present invention is directed to a specific embodiment of the transparent conductive film of any one of the seventh to ninth modes, wherein ion implantation is performed through plasma ion implantation.

An eleventh mode of the present invention is directed to a specific embodiment of the transparent conductive film of any one of the first to tenth modes, wherein the transparent conductive layer has a thickness of 20 to 500 nm, and the transparent conductive film has a sheet resistivity of 1,000 Ω/square or less.

A twelfth mode of the present invention is directed to a specific embodiment of the transparent conductive film of any one of the first to eleventh modes, wherein the zinc oxide-based conductive material contains at least one element selected from among gallium, indium, and silicon, in an amount of 0.01 to 10 mass%.

A thirteenth mode of the present invention is directed to a specific embodiment of the transparent conductive film of any of the first to twelfth modes, wherein the transparent conductive film exhibits a change ratio in sheet resistivity

represented by $T_1=(R_1-R_0)/R_0$ of 1.0 or less and a change ratio in sheet resistivity represented by $T_2=(R_2-R_0)/R_0$ of 1.0 or less, wherein $R_0$ represents an initial sheet resistivity, $R_1$ represents a sheet resistivity after the film has been placed under a 60°C-90% RH condition for three days, and $R_2$ represents a sheet resistivity after the film has been placed under a 60°C condition for three days.

In a fourteenth mode of the present invention, there is provided a method for producing a transparent conductive film, characterized in that the method comprises a step of performing ion implantation into a layer containing a polyorganosiloxane compound, to thereby form a gas barrier layer, and a step of forming, on the gas barrier layer, a transparent conductive layer formed of a zinc oxide-based conductive material.

A fifteenth mode of the present invention is directed to a specific embodiment of the method for producing a transparent conductive film of the fourteenth mode, wherein the ion implantation step includes ionization of at least one gas selected from the group consisting of hydrogen, nitrogen, oxygen, a rare gas, and a fluorocarbon, and implantation of the formed ion species.

A sixteenth mode of the present invention is directed to a specific embodiment of the method for producing a transparent conductive film of the fifteenth mode, wherein the ion implantation step is performed through plasma ion implantation.

A seventeenth mode of the present invention is directed to a specific embodiment of the method for producing a transparent conductive film of the fifteenth or sixteenth mode, wherein the ion implantation step includes performing ion implantation into a layer containing a polyorganosiloxane compound while the layer containing a polyorganosiloxane compound in the form of elongated film is conveyed in a specific direction.

In an eighteenth mode of the present invention, there is provided an electronic device employing a transparent conductive film as recited in any one of the first to fourteenth modes.

Effects of the Invention

The present invention enables provision of a transparent conductive film which exhibits excellent gas barrier performance and electrical conductivity and which exhibits low sheet resistivity and high electrical conductivity, even after having been placed in moist and high-temperature conditions.

According to the production method of the present invention, a transparent conductive film which exhibits excellent gas barrier performance and has electrical conductivity can be produced in a simple and safe manner.

Furthermore, by use of the transparent conductive film of the present invention, there can be produced an electronic device member which exhibits low sheet resistivity and high electrical conductivity, even after having been placed in moist and high-temperature conditions. The electronic device member, which exhibits excellent gas barrier performance and electrical conductivity, is applicable to production of flexible electronic devices.

Brief Description of the Drawings

[FIG. 1] A schematic configuration of a plasma ion implantation apparatus employed in the present invention.
[FIG. 2] A schematic configuration of a plasma ion implantation apparatus employed in the present invention.
[FIG. 3] A schematic cross-sectional view of an embodiment of transparent conductive film of the present invention.
[FIG. 4] A graph showing the oxygen atom concentration, carbon atom concentration, and silicon atom concentration (%) of the gas barrier layer of the transparent conductive film of Example 1.
[FIG. 5] A graph showing the oxygen atom concentration, carbon atom concentration, and silicon atom concentration (%) of the gas barrier layer of the transparent conductive film of Example 2.
[FIG. 6] A graph showing the oxygen atom concentration, carbon atom concentration, and silicon atom concentration (%) of the gas barrier layer of the transparent conductive film of Example 3.
[FIG. 7] A graph showing the oxygen atom concentration, carbon atom concentration, and silicon atom concentration (%) of the gas barrier layer of the transparent conductive film of Example 4.
[FIG. 8] A graph showing the oxygen atom concentration, carbon atom concentration, and silicon atom concentration (%) of the gas barrier layer of the transparent conductive film of Example 5.
[FIG. 9] A graph showing the oxygen atom concentration, carbon atom concentration, and silicon atom concentration (%) of the gas barrier layer of the transparent conductive film of Example 6.
[FIG. 10] A graph showing the oxygen atom concentration, carbon atom concentration, and silicon atom concentration (%) of the gas barrier layer of the transparent conductive film of Example 7.
[FIG. 11] A graph showing the oxygen atom concentration, carbon atom concentration, and silicon atom concentration (%) of the gas barrier layer of the transparent conductive film of Example 8.
[FIG. 12] A graph showing the oxygen atom concentration, carbon atom concentration, and silicon atom concentration

(%) of the gas barrier layer of the transparent conductive film of Example 9.

[FIG. 13] A graph showing the oxygen atom concentration, carbon atom concentration, and silicon atom concentration (%) of the gas barrier layer of the transparent conductive film of Example 10.

[FIG. 14] A graph showing the oxygen atom concentration, carbon atom concentration, and silicon atom concentration (%) of the gas barrier layer of the transparent conductive film of Comparative Example 1.

[FIG. 15] An XPS chart showing the silicon atom 2p electron binding energy distribution profile of the gas barrier layer of the transparent conductive film of Example 2. Modes for Carrying Out the Invention

The present invention will next be described in detail in terms of 1) a transparent conductive film, 2) a method for producing a transparent conductive film, and 3) an electronic device.

1) Transparent conductive film

1-1) Gas barrier layer and substrate of transparent conductive film

A characteristic feature of the transparent conductive film of the present invention which is a zinc oxide-based electrically conductive stacked structure, resides in that the film comprises a substrate and, formed on at least one surface of the substrate, (A) a gas barrier layer and (B) a transparent conductive layer formed of a zinc oxide-based conductive material, wherein the gas barrier layer is formed of a material containing at least oxygen atoms, carbon atoms, and silicon atoms, and includes a region in which the oxygen atom concentration gradually decreases and the carbon atom concentration gradually increases from the surface in the depth direction of the layer.

No particular limitation is imposed on the material forming the gas barrier layer which material contains at least oxygen atoms, carbon atoms, and silicon atoms, so long as the material is a polymer containing at least oxygen atoms, carbon atoms, and silicon atoms. However, in order to attain more excellent gas barrier performance, preferably, the surface layer part of the gas barrier layer has an oxygen atom fraction of 10 to 70%, a carbon atom fraction of 10 to 70%, and a silicon atom fraction of 5 to 35%, each atom fraction being calculated with respect to the sum of the fraction of the oxygen atoms, carbon atoms, and silicon atoms present in the gas barrier layer (i.e., makes the sum of the fraction of the oxygen atoms, carbon atoms, and silicon atoms into 100%). More preferably, the oxygen atom fraction of 15 to 65%, the carbon atom fraction is 15 to 65%, and the silicon atom fraction is 10 to 30%. The oxygen atom fraction, carbon atom fraction, and silicon atom fraction are determined through a method described in the Examples. The surface layer part of the gas barrier layer generally has a thickness of 5 to 100 nm, preferably 10 to 50 nm, more preferably 30 nm to 50 nm.

As described hereinbelow, the gas barrier layer may be a layer which is produced through ion implantation into a layer containing a polyorganosiloxane compound (hereinafter may be referred to as an "implantation layer") or a layer which is produced through plasma treatment of a layer containing a polyorganosiloxane compound.

The gas barrier layer preferably exhibits a silicon atom 2p electron binding energy peak at 102 to 104 eV, as measured through X-ray photoelectron spectrometry (XPS) of the surface layer part thereof.

For example, a polydimethylsiloxane layer exhibits a silicon atom 2p electron binding energy peak at about 101.5 eV as measured through X-ray photoelectron spectrometry (XPS), whereas an ion implantation layer (gas barrier layer) produced through implantation of argon ions to the polydimethylsiloxane layer exhibits a silicon atom 2p electron binding energy peak at about 103 eV as measured through X-ray photoelectron spectrometry (XPS) of the surface layer part. These values are almost equivalent to the silicon atom 2p electron binding energy peak of a known silicon-containing polymer (e.g., glass or silicon dioxide film) having gas barrier performance. Specifically, glass exhibits a silicon atom 2p electron binding energy peak at about 102.5 eV as measured through X-ray photoelectron spectrometry (XPS), and silicon dioxide film exhibits the same peak at about 103 eV. Therefore, the gas barrier layer of the present invention, which exhibits a silicon atom 2p electron binding energy peak at 102 to 104 eV at the surface layer part thereof, is thought to have the same structure as or a similar structure to that of glass or silicon dioxide film, thereby providing excellent gas barrier performance. The silicon atom 2p electron binding energy peak is measured through a method described in the Examples.

The gas barrier layer of the transparent conductive film of the present invention preferably contains at least a polyorganosiloxane compound.

Suitably, the gas barrier layer generally has a thickness of 30 nm to 200 $\mu$m, preferably 30 nm to 100 $\mu$m, more preferably 50 nm to 10 $\mu$m.

In the transparent conductive film of the present invention, the gas barrier layer preferably includes a layer which has been formed through ion implantation into a surface layer part of a layer containing a polyorganosiloxane compound.

No particular limitation is imposed on the backbone structure of the polyorganosiloxane compound employed in the transparent conductive film of the present invention, and the structure may be any of linear chain, ladder, and cage.

Examples of the linear chain backbone structure include those represented by formula (a). Examples of the ladder backbone structure include those represented by formula (b). Examples of the polyhedral main chain structure include those represented by formula (c).

[F3]

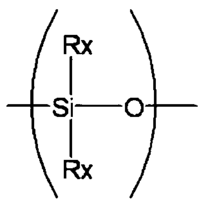

(a)

[F4]

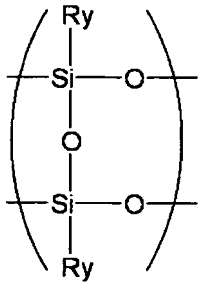

(b)

[F5]

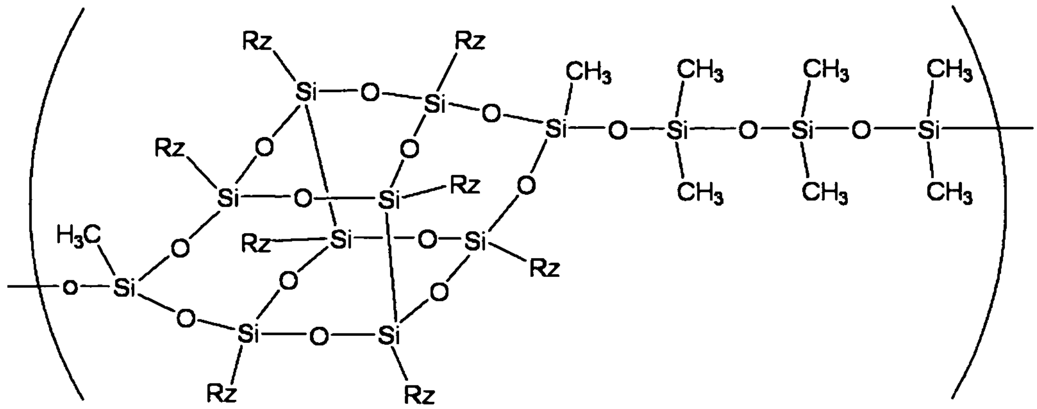

(c)

(wherein Rx, Ry, and Rz each represent a non-hydrolyzable group such as a hydrogen atom, a substituted or unsubstituted alkyl group, a substituted or unsubstituted alkenyl group, or a substituted or unsubstituted aryl group; a plurality of Rxs in formula (a) may be identical to or different from one another; a plurality of Rys in formula (b) may be identical to or different from one another; and a plurality of Rzs in formula (c) may be identical to or different from one another, excluding the case where the two Rxs in formula (a) are hydrogen atoms.

Examples of the alkyl group in the substituted or unsubstituted alkyl group include C1 to C10 alkyl groups such as methyl, ethyl, n-propyl, isopropyl, n-butyl, isobutyl, sec-butyl, t-butyl, n-pentyl, isopentyl, neopentyl, n-hexyl, n-heptyl, and n-octyl; and the like.

Examples of the alkenyl group include C2 to C10 alkenyl groups such as vinyl, 1-propenyl, 2-propenyl, 1-butenyl, 2-butenyl, and 3-butenyl; and the like.

Examples of the substituent of the alkyl group and alkenyl group include halogen atoms such as a fluorine atom, a chlorine atom, a bromine atom, and an iodine atom; a hydroxyl group; a thiol group; an epoxy group; a glycidoxy group; a (meth)acryloyloxy group; and substituted or unsubstituted aryl groups such as a phenyl group, a 4-methylphenyl group, and a 4-chlorophenyl group; and the like.

Examples of the aryl group of the substituted or unsubstituted aryl group include C6 to C10 aryl groups such as phenyl, 1-naphthyl, and 2-naphthyl; and the like.

Examples of the substituent of the aryl group include halogen atoms such as a fluorine atom, a chlorine atom, a bromine atom, and an iodine atom; C1 to C6 alkyl groups such as methyl and ethyl; C1 to C6 alkoxy groups such as methoxy and ethoxy; a nitro group; a cyano group; a hydroxyl group; a thiol group; an epoxy group; a glycidoxy group; a (meth)acryloyloxy group; and substituted or unsubstituted aryl groups such as a phenyl group, a 4-methylphenyl group, and a 4-chlorophenyl group; and the like.

Among them, each of Rx, Ry, and Rz is preferably a substituted or unsubstituted C1 to C6 alkyl group or a phenyl group, with methyl, ethyl, propyl, 3-glycidoxypropyl, or phenyl being particularly preferred; and the like.

Notably, a plurality of Rxs in formula (a), a plurality of Rys in formula (b), and a plurality of Rzs in formula (c) may be identical to or different from one another.

In the present invention, the polyorganosiloxane compound is preferably a linear-chain compound represented by formula (a) or a ladder compound represented by formula (b). From the viewpoints of availability and formation of an implantation layer having excellent gas barrier performance, particularly preferred is a linear-chain compound in which two Rxs in formula (a) are a methyl group or a phenyl group, or a ladder compound in which two Rys in formula (b) are a methyl group, a propyl group, a 3-glycidoxypropyl group, or a phenyl group.

The polyorganosiloxane compound may be produced through a known production method; i.e., polycondensation of a silane compound having a hydrolyzable functional group.

The silane compound employed may be appropriately selected in accordance with the structure of the target polyorganosiloxane compound. Specific examples of preferred silane compounds include 2-functional silane compounds such as dimethyldimethoxysilane, dimethyldiethoxysilane, diethyldimethoxysilane, and diethyldiethoxysilane; 3-functional silane compounds such as methyltrimethoxysilane, methyltriethoxysilane, ethyltrimethoxysilane, ethyltriethoxysilane, n-propyltrimethoxysilane, n-butyltriethoxysilane, 3-glycidoxypropyltrimethoxysilane, phenyltrimethoxysilane, phenyltriethoxysilane, and phenyldiethoxymethoxysilane; and 4-functional silane compounds such as tetramethoxysilane, tetraethoxysilane, tetra-n-propoxysilane, tetraisopropoxysilane, tetra-n-butoxysilane, tetra-t-butoxysilane, tetra-s-butoxysilane, methoxytriethoxysilane, dimethoxydiethoxysilane, and trimethoxyethoxysilane; and the like.

The polyorganosiloxane compound may be a commercial product of a releasing agent, an adhesive, a sealant, a coating, etc.

So long as the objects of the present invention are not hampered, the layer containing a polyorganosiloxane compound may further contain other ingredients. Examples of such additional ingredients include a curing agent, another polymer, an anti-aging agent, a photostabilizer, and a flame-retardant; and the like.

The layer containing a polyorganosiloxane compound preferably has a polyorganosiloxane compound content of 50 wt.% or more, more preferably 70 wt.% or more, particularly preferably 90 wt.% or more, since an implantation layer having excellent gas barrier performance can be formed.

No particular limitation is imposed on the method for forming the layer containing a polyorganosiloxane compound. In one specific method, a layer-forming solution containing at least one polyorganosiloxane compound, an optional ingredient, a solvent, etc. is applied onto a substrate (details of which will be described hereinbelow), and the applied coating is dried with optional heating.

No particular limitation is imposed on the thickness of the formed layer containing a polyorganosiloxane compound, and the thickness is generally 30 nm to 200 $\mu$m, preferably 50 nm to 100 $\mu$m.

The aforementioned implantation layer is a layer formed by ion implantation into the layer containing a polyorganosiloxane compound.

The amount of ions implanted may be appropriately determined in accordance with the purpose of use of the transparent conductive film (e.g., required gas barrier performance, transparency, etc.).

Examples of the ion species implanted include ions of a rare gas such as argon, helium, neon, krypton, or xenon; ions of fluorocarbon, hydrogen, nitrogen, oxygen, carbon dioxide, chlorine, fluorine, or sulfur; ions of electrically conductive metal such as gold, silver, copper, platinum, nickel, palladium, chromium, titanium, molybdenum, niobium, tantalum, tungsten, or aluminum; and the like.

Among them, ions of at least one member selected from the group consisting of hydrogen, oxygen, nitrogen, rare gas, and fluorocarbon is preferred, with ions of nitrogen, oxygen, argon, or helium being particularly preferred, since these ion species can be implanted in a more simple manner and provides an implantation layer having remarkably excellent gas barrier performance and transparency.

No particular limitation is imposed on the ion implantation method. In one specific procedure, a layer containing

a polyorganosiloxane compound is formed, and then, ions are implanted to the layer containing a polyorganosiloxane compound.

Examples of the ion implantation method include irradiating a target layer with ions (ion beam) accelerated by an electric field, and implanting ions in a plasma. Of these, the latter plasma ion implantation is preferably employed in the present invention, since a gas barrier layer can be readily formed.

In one specific procedure of plasma ion implantation, a plasma is generated in an atmosphere containing a plasma-generating gas (e.g., rare gas), and a negative high-voltage pulse is applied to a layer containing a polyorganosiloxane compound, whereby ions (cations) in the plasma are implanted to the surface layer part of the layer containing a polyorganosiloxane compound.

Completion of ion implantation may be confirmed through elemental analysis of the surface layer part of the gas barrier layer by X-ray photoelectron spectrometry (XPS).

No particular limitation is imposed on the substrate employed in the present invention, so long as it is suited for the transparent conductive film. Examples of the material of the substrate include polyimde, polyamide, polyamide-imide, polyphenylene ether, polyether ketone, polyether ether ketone, polyolefin, polyester, polycarbonate, polysulfone, polyether sulfone, polyphenyl sulfone, modified polysulfone, polyphenylene sulfide, polyarylate, acrylic resin, cycloolefin polymer, aromatic polymer, polyurethane, and film produced from thermally curable or radiation-curable resin by heat or radiation. In addition to the material, the substrate may further contain various additives such as an anti-oxidant, a flame-retardant, a high-refractive index material, a low-refractive index material, and a lubricant, so long as gas barrier performance, transparency, and electrical conductivity are not impaired.

Among the above materials, polyester, polyamide, and cycloolefin polymer are preferred, with polyester and cycloolefin polymer being more preferred, since these material have dimensional stability under high-temperature conditions, excellent transparency, and general usability.

Examples of the polyester include polyethylene terephthalate, polybutylene terephthalate, polyethylene naphthalate, and polyarylate.

Examples of the polyamide include completely aromatic polyamides, nylon 6, nylon 66, and nylon copolymer.

Examples of the cycloolefin polymer include norbornene polymer, monocyclic olefin polymer, cyclic conjugated diene polymer, vinyl alicyclic hydrocarbon polymer, and hydrogenated products thereof. Specific examples include Apel (ethylene-cycloolefin copolymer, product of Mitsui Chemicals Inc.), Arton (norbornene polymer, product of JSR), and ZEONOR (norbornene polymer, product of Nippon Zeon Co., Ltd.). The substrate preferably has a thickness of 0.01 to 0.5 mm, more preferably 0.05 to 0.25 mm. When the thickness falls within the range, suitable transparency and flexibility can be attained, and the film product can be easily handled.

1-2) Zinc oxide-based conductive layer of transparent conductive film

In the present invention, the zinc oxide-based conductive layer is a transparent conductive layer formed of a zinc oxide-based conductive material, and the zinc oxide-based conductive material predominantly contains zinc oxide preferably in an amount of 90 mass% or more. However, the composition of the zinc oxide-based conductive layer is not limited, and the layer may further contain an additive element or an additive for lowering resistivity. Examples of such an additive include aluminum, indium, boron, gallium, silicon, tin, germanium, antimony, iridium, rhenium, cerium, zirconium, scandium, and yttrium. The layer may contain at least one member of the additive elements and additives, and the total amount of such additives is preferably 0.05 to 15 mass%. The zinc oxide-based transparent conductive material may be formed through a known film formation method such as sputtering, ion plating, vacuum vapor deposition, or chemical vapor deposition. Before film formation of transparent conductive material, a film having a gas barrier performance may be heated in vacuum or air at a temperature not higher than the melting temperature of the film, or may be subjected to plasma treatment or irradiation with a UV beam.

The thickness of the zinc oxide-based conductive layer, which varies depending on the use thereof, is, for example, 10 nm to 5 $\mu$m, preferably 20 nm to 1,000 nm, more preferably 50 to 500 nm.

1-3) Transparent conductive film

The transparent conductive film of the present invention is a zinc oxide-based electrically conductive stacked structure, wherein the film comprises a substrate and, formed on at least one surface of the substrate, (A) a gas barrier layer and (B) a transparent conductive layer formed of a zinc oxide-based conductive material and may further include an optional layer. No particular limitation is imposed on the location of the optional layer, and the optional layer may be provided on at least one surface of the substrate, on at least one surface of the gas barrier layer, on at least one surface of the zinc oxide-based conductive layer. One example of the optional layer is a hard coating layer which shields oligomeric ingredients and low-molecular-weight ingredients contained in the substrate. No particular limitation is imposed on the material of the hard coating layer, and known materials such as energy-beam-curable resin and heat-curable resin may

be employed. Alternatively, a hard coating layer may be formed on the gas barrier layer in order to protect the gas barrier layer. The hard coating layer preferably has a thickness of 0.1 to 20 μm, particularly preferably 1 to 10 μm.

No particular limitation is imposed on the thickness of the transparent conductive film of the present invention. In the case where the film is employed as a member of an electronic device, the thickness is preferably about 1 to about 1,000 μm.

The excellent gas barrier performance of the transparent conductive film of the present invention can be confirmed by a small gas (e.g., water vapor) permeability of the transparent conductive film of the present invention. Specifically, the water vapor permeability is preferably 5 $g/m^2$/day or less, more preferably 3 $g/m^2$/day or less. The gas (e.g., water vapor) permeability of the film may be measured by means of a known gas permeability measuring apparatus.

The excellent transparency of the transparent conductive film of the present invention can be confirmed by a high visible light transmittance of the transparent conductive film of the present invention. The visible light transmittance is preferably 70% or higher as total luminous transmittance, more preferably 75% or higher. The visible light transmittance of the transparent conductive film may be measured by means of a known visible light transmittance measuring apparatus.

The transparent conductive film of the present invention preferably has a sheet resistivity of 1,000 Ω/square or less, more preferably 500 Ω/square or less, yet more preferably 100 Ω/square or less. The sheet resistivity of the transparent conductive film may be measured by means of a method described in the Examples.

The transparent conductive film of the present invention preferably exhibits a change ratio in sheet resistivity represented by $T_1=(R_1-R_0)/R_0$ of 1.0 or less (more preferably 0.5 or less, still more preferably 0.3 or less, yet more preferably 0.1 or less), and a change ratio in sheet resistivity represented by $T_2=(R_2-R_0)/R_0$ of 1.0 or less (more preferably 0.2 or less), wherein $R_0$ represents an initial sheet resistivity, $R_1$ represents a sheet resistivity after the film has been placed under a 60°C-90% RH (relative humidity) condition for three days, and $R_2$ represents a sheet resistivity after the film has been placed under a 60°C condition for three days.

By virtue of excellent gas barrier performance and transparent electrical conductivity, the transparent conductive film of the present invention, when employed in an electronic device, can prevent deterioration of the elements therein which would otherwise be caused by gas (e.g., water vapor). Also, by virtue of high optical transparency, the transparent conductive film of the present invention is suitably employed as a display member such as a tough panel, a liquid crystal display, an EL display; a solar battery electrode used in solar batteries or the like; an electrode for organic transistors, and the like.

2) Method for producing transparent conductive film

A characteristic feature of the method of the present invention for producing a transparent conductive film resides in that the method comprises a step of performing ion implantation into a layer containing a polyorganosiloxane compound, to thereby form a gas barrier layer, and a step of forming, on the gas barrier layer, a transparent conductive layer formed of a zinc oxide-based conductive material.

In the method of the present invention for producing a transparent conductive film, preferably, ions are implanted to a layer containing a polyorganosiloxane compound included in a film, while the film having a layer containing a polyorganosiloxane compound is conveyed in a specific direction, to thereby produce a film having a gas barrier performance. An example of the film having a layer containing a polyorganosiloxane compound is a film formed of a substrate on which a layer containing a polyorganosiloxane compound is provided.

Through the above production method, the following procedure can be realized. Specifically, an elongated film is unwound from a unwinding roller, and ions are implanted to the film while the film is conveyed in a specific direction. The thus-processed film is wound by means of a winding roller. Thus, ion-implanted film can be continuously produced.

The film which includes a layer containing polyorganosiloxane compound may be a single layer containing a polyorganosiloxane compound or a multi-layer film including an additional layer. Examples of the additional layer which may be employed in the invention are the same as described above.

The thickness of the film is preferably 1 μm to 500 μm, more preferably 5 μm to 300 μm, from the viewpoint of operability in unwinding, winding, and conveying.

No particular limitation is imposed on the ion implantation into the layer containing a polyorganosiloxane compound. Among various methods, plasma ion implantation is particularly preferably employed so as to form an ion implantation layer in the surface layer part of the layer.

In the plasma ion implantation method, a negative high-voltage pulse is applied to a layer containing a polyorganosiloxane compound exposed to plasma, whereby ions in the plasma are implanted to the surface layer part of the layer, to thereby form an ion implantation layer.

A preferred mode of plasma ion implantation (A) includes implanting ions present in a plasma generated by an external electric field to the surface layer part of the layer. Another preferred mode of plasma ion implantation (B) includes implanting ions present in a plasma generated only by the negative high-voltage pulse applied to the layer (not employing an external electric field) to the surface layer part of the layer.

In the mode (A), the pressure at ion implantation (i.e., the pressure at plasma ion implantation) is preferably adjusted to 0.01 to 1 Pa. When the plasma ion implantation pressure falls within the range, a uniform implantation layer can be formed easily and effectively, whereby an implantation layer having transparency and gas barrier performance can be effectively formed.

In the mode (B), high vacuum degree is not needed, and the operation can be easily carried out, whereby the processing time can be remarkably shortened. Also, the entirety of the layer can be uniformly treated, and high-energy ions in the plasma can be continuously implanted to the surface layer part of the layer during application of negative high-voltage pulse. Furthermore, a uniform implantation layer can be formed in the surface layer part of the layer merely through application of negative high-voltage pulse, without employing a special means such as high-frequency (e.g., radio frequency (high frequency, hereinafter abbreviated as "RF") or microwave) power source.

In either of mode (A) or (B), the pulse width of the negative high-voltage pulse at the time of pulse application (i.e., ion implantation) is preferably 1 to 15 $\mu$sec. When the pulse width falls within the range, a transparent and uniform implantation layer can be formed easily and effectively.

The application voltage for generating plasma is preferably -1 kV to -50 kV, more preferably -1 kV to -30 kV, particularly preferably -5 kV to -20 kV. When the application voltage during ion implantation is higher than -1 kV, ion implantation (dose) is insufficient, to thereby fail to attain performance of interest, whereas when the voltage is lower than -50 kV, the film is electrically charged during ion implantation, causing undesired coloring or the like, which is not preferred.

Examples of the ion species implanted include ions of a rare gas such as argon, helium, neon, krypton, or xenon; ions of fluorocarbon, hydrogen, nitrogen, oxygen, carbon dioxide, chlorine, fluorine, or sulfur; ions of electrically conductive metal such as gold, silver, copper, platinum, nickel, palladium, chromium, titanium, molybdenum, niobium, tantalum, tungsten, or aluminum. Among them, ions of at least one member selected from the group consisting of hydrogen, oxygen, nitrogen, rare gas, and fluorocarbon is preferred, with ions of nitrogen, oxygen, argon, or helium being more preferred, since these ion species can be implanted in a simple manner and a film having remarkably excellent gas barrier performance and transparency can be produced.

For ion implantation of ions present in the plasma to the surface layer part of the layer, a plasma ion implantation apparatus is employed.

Specific examples of the plasma ion implantation apparatus include the following:

($\alpha$) a plasma ion implantation apparatus in which high-frequency power is superimposed on a feed-through for applying negative high-voltage pulse to a layer containing a polyorganosiloxane compound (hereinafter may be referred to as an "ion implantation target layer"), wherein the ion implantation target layer is surrounded by the plasma, and induction, implantation, collision, and deposition of ions in the plasma are performed (Japanese Patent Application Laid-Open (*kokai*) No. 2001-26887),

($\beta$) a plasma ion implantation apparatus having an antenna in a chamber in which a plasma is generated by high-frequency power, and after the plasma has reached the surround of the ion implantation target layer, positive pulse and negative pulse are alternatingly applied to the ion implantation target layer, whereby electrons in the plasma are inducted and caused to be collided by the positive pulse, to thereby heat the ion implantation target layer, and ions in the plasma are induced and implanted through application of the negative pulse while the pulse constant is controlled for controlling temperature (Japanese Patent Application laid-Open (*kokai*) No. 2001-156013),

($\gamma$) a plasma ion implantation apparatus in which a plasma is generated by means of only an external electric field such as a high-frequency (e.g., microwave) power source, and ions in the plasma are induced and implanted through application of high-voltage pulse, and

($\delta$) a plasma ion implantation apparatus in which a plasma is generated by means of an electric field generated through application of high-voltage pulse without employing an external electric field, and ions in the plasma are implanted.

Among these plasma ion implantation apparatuses, the plasma ion implantation apparatus ($\gamma$) or ($\delta$) is preferably employed, by virtue of simple operability, very shortened processing time, and suitability to continuous operation.

Hereinafter, an ion implantation technique employing the aforementioned plasma ion implantation apparatuses ($\gamma$) or ($\delta$) will be described in detail with reference to the drawings.

FIG. 1 is a schematic representation of a continuous plasma ion implantation apparatus employing the plasma ion implantation apparatus ($\gamma$) above.

In FIG. 1(a), 1a denotes an elongated film including a layer containing a polyorganosiloxane compound (hereinafter may be referred to as a "film"), 2a a high-voltage application rotatable can, 3a an unwinding roller for feeding the film 1a before ion implantation, 4 a plasma discharge electrode (external electric field), 5a a winding roller for winding a film 1b having the layer containing a polyorganosiloxane compound which has been ion-implanted and which has a gas barrier performance, to thereby provide a rolled film, 6a a feed roller, 7a a high-voltage pulse power source, 10a a

gas inlet, 11a a chamber, and 20a an oil diffusion pump. FIG. 1(b) is a perspective view of the aforementioned high-voltage application rotatable can 2a. The numeral 13 denotes a center axis, and 15 denotes a high-voltage-introduction terminal (feed-through).

The elongated film 1a including a layer containing a polyorganosiloxane compound employed in this embodiment is a film formed of a substrate on which the layer containing a polyorganosiloxane compound is formed.

In the continuous plasma ion implantation apparatus shown in FIG. 1, the film 1a is conveyed from the unwinding roller 3a in the direction denoted by arrow X (FIG. 1) in the chamber 11a, passes around the high-voltage application rotatable can 2a, and is wound by the winding roller 5a. No particular limitation is imposed on the method of winding or conveying the film 1a. In the present embodiment, the film 1a is conveyed by rotating the high-voltage application rotatable can 2a at a constant rotating speed. The rotation of the high-voltage application rotatable can 2a is performed through rotating the center axis 13 of the high-voltage-introduction terminal 15 by means of a motor.

Members such as the high-voltage-introduction terminal 15 and a plurality of feed rollers 6a which come into contact with the film 1a are formed of an insulator (e.g., alumina coated with a resin such as polytetrafluoroethylene). The high-voltage application rotatable can 2a may be formed of a conductor (e.g., stainless steel).

The film 1a conveying speed may be appropriately predetermined. No particular limitation is imposed on the conveying speed, so long as ions are implanted to the surface layer part of the film 1a (a layer containing a polyorganosiloxane compound) while the film 1a is conveyed from the unwinding roller 3a and is wound by the winding roller 5a, and a sufficient period of time required for forming an implantation layer is ensured. The film winding speed (i.e., line speed), which varies depending on factors such as applied voltage and apparatus scale, is generally 0.1 to 3 m/min, preferably 0.2 to 2.5 m/min.

Firstly, the chamber 11a is evacuated by means of the oil diffusion pump 20a connected to the rotary pump. The degree of vacuum is generally $1 \times 10^{-2}$ Pa or less, preferably $1 \times 10^{-3}$ Pa or less.

Then, a gas for ion implantation (hereinafter may be referred to as an "ion implantation gas") is fed into the chamber 11a via the gas inlet 10a, to thereby attain a reduced-pressure ion implantation gas atmosphere in the chamber 11a.

Subsequently, a plasma is generated by means of the plasma discharge electrode 4 (external electric field). Plasma generation is performed through known means, for example, a high-frequency (e.g., microwave or RF) power source.

Separately, negative high-voltage pulse 9a is applied by means of the high-voltage pulse power source 7a, which is connected to the high-voltage application rotatable can 2a via the high-voltage-introduction terminal 15. Through application of negative high-voltage pulse to the high-voltage application rotatable can 2a, ions are induced in the plasma, and the ions are implanted to the surface of the film surrounding the high-voltage application rotatable can 2a (FIG. 1 (a), arrow Y), to thereby form a film 1b including a gas barrier layer.

As described above, the pressure at ion implantation (plasma gas pressure in the chamber 11a) is preferably 0.01 to 1 Pa. The pulse width at ion implantation is preferably 1 to 15 μsec. The voltage applied to the high-voltage application rotatable can 2a is preferably -1 kV to -50 kV.

Next will be described a procedure of ion implantation into the surface layer part, which is a layer containing a polyorganosiloxane compound of the film, by means of a continuous plasma ion implantation apparatus as shown in FIG 2.

The apparatus shown in FIG. 2 includes the aforementioned plasma ion implantation apparatus (δ). The plasma ion implantation apparatus is adapted to generate plasma only by an electric field generated by high-voltage pulse without employing an external electric field (i.e., the plasma discharge electrode 4 shown in FIG. 1).

In the continuous plasma ion implantation apparatus shown in FIG. 2, in a manner similar to that employed in the apparatus shown in FIG. 1, a film (film-shape molded product) 1c is conveyed from the unwinding roller 3b in the direction denoted by arrow X in FIG. 2, through rotation of the high-voltage application rotatable can 2b, and is wound by the winding roller 5b via a plurality of feed rollers 6b.

In the continuous plasma ion implantation apparatus shown in FIG. 2, ions are implanted to the surface layer part of the layer containing a polyorganosiloxane compound included in the film through the following procedure.

Firstly, similar to the plasma ion implantation apparatus shown in FIG. 1, a film 1c is placed in a chamber 11b, and the chamber 11b is evacuated by means of the oil diffusion pump 20b connected to the rotary pump.

Then, an ion implantation gas is fed into the chamber 11b via the gas inlet 10b, to thereby attain a reduced-pressure ion implantation gas atmosphere in the chamber 11b.

The pressure at ion implantation (plasma gas pressure in the chamber 11b) is 10 Pa or less, preferably 0.01 to 5 Pa, more preferably 0.01 to 1 Pa.

Then, a high-voltage pulse 9b is applied to the film 1c by means of a high-voltage pulse power source 7b connected to the high-voltage application rotatable can 2b, while the film 1c is conveyed in the direction X shown in FIG. 2.

Through application of negative high-voltage to the high-voltage application rotatable can 2b, a plasma is generated along the film 1c surrounding the high-voltage application rotatable can 2b. Thus, ions are induced in the plasma, and the ions are implanted to the surface of the film 1c surrounding the high-voltage application rotatable can

2b (FIG. 2, arrow Y). When ions are implanted to the surface layer part of the layer containing a polyorganosiloxane compound included in the film 1c, an implantation layer is formed as the surface layer part of the film, to thereby form a film 1d including a gas barrier layer.

The voltage applied to the high-voltage application rotatable can 2b and the pulse width are the same as those employed in the continuous plasma ion implantation apparatus shown in FIG. 1.

In the plasma ion implantation apparatus shown in FIG. 2, the high-voltage pulse power source serves as plasma generation means. Therefore, without employing any particular means such as a high-frequency (e.g., microwave or RF) power source, a plasma can be generated only through application of a negative high-voltage pulse, and ions in the plasma can be implanted to the surface layer part of the layer containing a polyorganosiloxane compound included in the film. As a result, such an implantation layer can be continuously formed, whereby film having an implantation layer in the surface layer part thereof can be mass-produced.

Another method of producing a gas barrier layer included in the transparent conductive film of the present invention is performing plasma treatment of the surface of the layer containing a polyorganosiloxane compound. In one mode of the plasma treatment, a plasma is generated from a plasma-generating gas such as hydrogen, oxygen, nitrogen, or a rare gas (e.g., helium, argon, or neon) by an external electric field, and a layer containing a polyorganosiloxane compound is exposed to the plasma. The plasma treatment is typically performed under the following conditions: plasma-generating gas flow rate: 1 to 100 mL/min, pressure: 0.1 to 50 Pa, temperature: 20 to 50°C, and time: 1 min to 20 min.

FIG. 3 is a schematic cross-section of a typical structure of the transparent conductive film of the present invention. As shown in FIG. 3, a transparent conductive film 100 has a film-shape substrate 110, a gas barrier layer 120, a transparent conductive layer 130 formed of a zinc oxide-based conductive material. The gas barrier layer 120 includes a surface layer part 121 of the gas barrier layer 120. The transparent conductive layer 130 formed of a zinc oxide-based conductive material is provided on the gas barrier layer 120.

The transparent conductive film 100 may further include a layer formed of another material. In the above structure, the transparent conductive layer 130 is directly formed on the gas barrier layer 120. However, an optional layer formed of another material may intervene between the two layers. Alternatively, an optional layer formed of another material may intervene between the film-shape substrate 110 and the gas barrier layer 120. Still alternatively, such an optional layer may intervene both spaces. Yet alternatively, an optional layer formed of another material may be formed on the surface of the film-shape substrate 110 opposite the surface on which the gas barrier layer 120 is formed. An optional layer formed of another material may be formed on the surface of the transparent conductive layer 130 opposite the surface on which the gas barrier layer 120 is formed.

3) Electronic device

The transparent conductive film of the present invention exhibits excellent gas barrier performance and transparent electrical conductivity. Thus, when the transparent conductive film is used in an electronic device, deterioration of an element thereof which would otherwise be caused by gas (e.g., water vapor) can be prevented. Also, by virtue of high optical transparency, the transparent conductive film of the invention is suitably employed as a display member such as a touch panel, a liquid crystal display, or an EL display; a solar battery electrode for use in a solar battery; an electrode for an organic transistor, etc.

The electronic device of the present invention has the transparent conductive film of the present invention. Examples of the electronic device include a liquid crystal display, an organic EL display, an inorganic EL display, an electronic paper, a touch panel, a solar battery, and an organic transistor.

The electronic device of the present invention, which has an electronic device member formed of the transparent conductive film of the present invention, exhibits excellent gas barrier performance and transparent electrical conductivity.

Examples

The present invention will next be described in more detail by way of examples, which should not be construed as limiting the present invention thereto.

The following plasma ion implantation apparatus, X-ray photoelectron spectrometer (XPS) (with measurement conditions), water vapor permeability measurement apparatus (with measurement conditions), visible-light transmittance measurement apparatus, and sheet resistivity measurement conditions were employed. Notably, the plasma ion implantation apparatus performs ion implantation through employment of an external electric field.

(Plasma ion implantation apparatus)

RF power source: Model RF56000, product of JEOL Ltd. High-voltage pulse power source: PV-3-HSHV-0835, product of Kurita Seisakusyo Co., Ltd.

(X-ray photoelectron spectrometer)

Spectrometer: PHI Quantera SXM, product of ULVAC Phi Inc.
X-ray beam diameter: 100 μm
Power: 25 W
Voltage: 15 kV
Take-off angle: 45°

Under the above measurement conditions, the following measurement was performed.

Measurement of oxygen atom fraction, carbon atom fraction, and silicon atom fraction, and silicon atom 2p electron binding energy peak

The ion-implanted surface of each of the films obtained in Examples 1 to 10 and 19 and Comparative Example 1, the plasma-treated surface of the film obtained in Example 19, and the surface layer part of the layer containing polydimethylsiloxane compound of the film of Comparative Example 1 were analyzed in terms of oxygen atom fraction, carbon atom fraction, and silicon atom fraction, and silicon atom 2p electron binding energy peak. Thereafter, each of the plasma ion-implanted surfaces (Examples 1 to 10), the plasma-treated surface of the polydimethylsiloxane-containing layer (Example 19), and the surface of the polydimethylsiloxane-containing layer (Comparative Example 1) was subjected to sputtering with argon gas from the surface toward the depth direction, and the surface newly exposed through sputtering was analyzed in terms of each atom fraction. The analysis was repeated, to thereby obtain the depth profile of each atom fraction and the position of the silicon atom 2p electron binding energy peak.

In the above measurement, the voltage at the time of sputtering with argon gas was adjusted to -4 kV, and the sputtering time was adjusted to 12 seconds/sputtering process. The sputtering rate was adjusted to 100 nm/min in Examples 1 to 6, Example 19, and Comparative Example 1, 70 nm/min in Examples 7 and 8, and 30 nm/min in Examples 9 and 10.

The atom fraction (i.e., atomic concentration) was calculated by dividing the obtained peak area attributed to each atom by the sum of the obtained peak areas attributed to oxygen atoms, carbon atoms, and silicon atoms (i.e., makes the sum of the fraction of the oxygen atoms, carbon atoms, and silicon atoms into 100%).

(Water vapor permeability measurement apparatus)

Permeability measurement apparatus: L80-5000, product of LYSSY

Measurement conditions: RH90%, 40°C

(Visible light transmittance measurement apparatus)

The total luminous transmittance was measured by means of Hazemeter NDH2000 (product of Nippon Denshoku Industries Co., Ltd.) employed as a visible light transmittance measurement apparatus. In the measurement, the zinc oxide film surface-transparent conductive layer-of each sample was employed as a light incident surface.

(Sheet resistivity)

The sheet resistivity of each transparent conductive film in a 23°C-50% RH atmosphere was measured by means of LORESTA-GP MCP-T600 (product of Mitsubishi Chemical Co., Ltd.), with PROBE TYPE LSP (product of Mitsubishi Chemical Analytech Co., Ltd.) as a probe.

(Moisture- and heat-resistance test)

A transparent conductive film test piece was placed for three days in a 60°C atmosphere or a 60°C-90% RH atmosphere. After taking out from each atmosphere, the test piece was reconditioned for one day in a 23°C-50% RH atmosphere, and the sheet resistivity thereof was measured. From the sheet resistivity $R_0$ (before test), the sheet resistivity $R_1$ (after placement in a 60°C atmosphere for 3 days), and the sheet resistivity $R_2$ (after placement in a 60°C-90% RH atmosphere for 3 days), $T_1$ and $T_2$ (evaluation parameters) were calculated by the following equations:

$$T_1 = (R_1 - R_0) / R_0$$

$$T_2 = (R_2 - R_0) / R_0 .$$

Example 1

A substrate made of polyethylene naphthalate (product of Teijin DuPont, thickness: 200 μm, trade name: Q65FA) (hereinafter referred to as PEN film) was employed. Onto an easy-adhesion layer of the substrate, silicone resin (A) containing polydimethylsiloxane as a predominant component (silicone releasing agent "KS 835," product of Shin-Etsu Chemical Co., Ltd.) was applied as a polyorganosiloxane compound by means of a Mayer bar. The thus-coated substrate was heated at 120°C for two minutes, to thereby form a layer containing silicone releasing agent A and having a thickness of 100 nm as a polydimethylsiloxane layer. Subsequently, nitrogen ions were implanted through plasma ion implantation into the surface of the polydimethylsiloxane layer by means of the plasma ion implantation apparatus shown in FIG. 1, to thereby form a gas barrier layer. On the formed gas barrier layer, a zinc oxide film containing gallium oxide in an amount of 5.7 mass% was formed through sputtering to a thickness of 100 nm, whereby a transparent conductive film of Example 1 was produced.
Plasma ion implantation was performed under the following conditions.

- plasma-generating gas : $N_2$
- Duty ratio: 0.50
- Repetition frequency: 1,000 Hz
- Applied voltage : -10 kV
- RF power source: frequency 13.56 MHz, applied power 1,000 W
- Chamber pressure: 0.2 Pa
- Pulse width: 5 μsec
- Process time (ion implantation time): 5 min
- Conveying speed: 0.4 m/min

The transparent conductive layer of zinc oxide-based conductive material was formed through DC magnetron sputtering by use of a zinc oxide target containing 5.7 mass% $Ga_2O_3$ (product of Sumitomo Metal Mining Co., Ltd.) to a film thickness of 100 nm.
Sputtering was performed under the following conditions.

- Substrate temperature: room temperature
- DC output: 500 W
- Carrier gas: argon and oxygen (relative flow rate 100:1)
- Vacuum degree: 0.3 to 0.8 Pa

Example 2

The procedure of Example 1 was repeated, except that argon (Ar) was used as a plasma-generating gas, to thereby form a transparent conductive film of Example 2.

Example 3

The procedure of Example 1 was repeated, except that helium (He) was used as a plasma-generating gas, to thereby form a transparent conductive film of Example 3.

Example 4

The procedure of Example 1 was repeated, except that oxygen ($O_2$) was used as a plasma-generating gas, to thereby form a transparent conductive film of Example 4.

Example 5

The same PEN film as employed in Example 1 was employed. Onto a surface of the substrate, silicone resin (B) containing a polyorganosiloxane compound (methyl of polydimethylsiloxane partially substituted by phenyl group) as a predominant component ("X62-9201B," product of Shin-Etsu Chemical Co., Ltd.) was applied by means of a Mayer bar. The thus-coated substrate was heated at 120°C for two minutes, to thereby form a layer containing phenyl-group-bearing polyorganosiloxane and having a thickness of 100 nm. Subsequently, in a manner similar to that of Example 1, nitrogen ions were implanted through plasma ion implantation into the surface of the layer containing silicone resin (B), to thereby form a gas barrier layer. Then, a transparent conductive layer was formed in a manner similar to that of Example 1, to thereby produce a transparent conductive film of Example 5.

Example 6

The procedure of Example 5 was repeated, except that argon (Ar) was used as a plasma-generating gas, to thereby form a transparent conductive film of Example 6.

Example 7

n-Propyltrimethoxysilane (product of Tokyo Kasei Kogyo Co., Ltd.) (3.29 g (20 mmol)), 3-glycidoxypropyltrimethoxysilane (product of Tokyo Kasei Kogyo Co., Ltd.) (4.73 g (20 mmol)), toluene (20 mL), distilled water (10 mL), and phosphoric acid (product of Kanto Kagaku) (0.10 g (1 mmol)) were mixed, and the mixture was allowed to react at room temperature for 24 hours. After completion of reaction, aqueous saturated sodium hydrogencarbonate was added to the reaction mixture. Ethyl acetate (100 mL) was added thereto for phase separation, and the organic layer was removed. The organic layer was washed twice with distilled water and dried over magnesium sulfate anhydrate, followed by filtering off magnesium sulfate. The thus-obtained filtrate was added dropwise to a large amount of n-hexane, to thereby precipitate a product. n-Hexane was separated through decantation, and the precipitated product was dissolved in THF, to thereby recover the product. Tetrahydrofuran (THF) was removed under reduced pressure by means of an evaporator, and the solid was dried in vacuum, to thereby yield polysilsesquioxane (polyorganosiloxane compound) having a ladder structure. The weight average molecular weight of the polymer was found to be 2,000. The polysilsesquioxane was dissolved in toluene, and the solution (solid content: 2 mass%) was applied onto a PEN film by means of a Mayer bar as employed in Example 1, and the coated substrate was heated at 125°C for 6 hours for curing, to thereby form a polysilsesquioxane layer having a thickness of 100 nm. In a manner similar to that of Example 1, nitrogen ions were implanted by means of a plasma ion implantation apparatus to the surface of the cured polysilsesquioxane layer, to thereby form a gas barrier layer. Then, a transparent conductive layer was formed in a manner similar to that of Example 1, to thereby produce a transparent conductive film of Example 7. Notably, weight average molecular weight was determined through gel permeation chromatography (GPC) and reduced to polystyrene. Before performing plasma ion implantation, the gas barrier layer was found to have a water vapor permeability of 12.1 (g/$m^2$/day).

Example 8

The procedure of Example 7 was repeated, except that argon (Ar) was used as a plasma-generating gas, to thereby form a transparent conductive film of Example 8.

Example 9

Phenyltrimethoxysilane (product of Tokyo Kasei Kogyo Co., Ltd.) (7.94 g (40 mmol)), toluene (20 mL), distilled water (10 mL), and phosphoric acid (product of Kanto Kagaku) (0.10 g (1 mmol)) were mixed, and the mixture was allowed to react at room temperature for 24 hours. After completion of reaction, aqueous saturated sodium hydrogencarbonate was added to the reaction mixture. Ethyl acetate (100 mL) was added thereto for phase separation, and the organic layer was removed. The organic layer was washed twice with distilled water and dried over magnesium sulfate anhydrate, followed by filtering off magnesium sulfate. The thus-obtained filtrate was added dropwise to a large amount of n-hexane, to thereby precipitate a product. n-Hexane was separated through decantation, and the precipitated product was dissolved in THF, to thereby recover the product. Tetrahydrofuran (THF) was removed under reduced pressure by means of an evaporator, and the solid was dried in vacuum, to thereby yield polysilsesquioxane (polyorganosiloxane compound) having a ladder structure. The weight average molecular weight of the polymer was found to be 1,600. The polysilsesquioxane was dissolved in toluene, and the solution (solid content: 2 mass%) was applied onto a PEN film by means of a Mayer bar as employed in Example 1, and the coated substrate was heated at 125°C for 6 hours, to thereby form a polysilsesquioxane layer having a thickness of 100 nm. In a manner similar to that of Example 1, nitrogen ions

were implanted by means of a plasma ion implantation apparatus to the surface of the cured polysilsesquioxane layer, to thereby form a gas barrier layer. Then, a transparent conductive layer was formed in a manner similar to that of Example 1, to thereby produce a transparent conductive film of Example 9. Before performing plasma ion implantation, the gas barrier layer was found to have a water vapor permeability of 11.7 ($g/m^2/day$).

Example 10

The procedure of Example 9 was repeated, except that argon (Ar) was used as a plasma-generating gas, to thereby form a transparent conductive film of Example 10.

Example 11

The procedure of Example 1 was repeated, except that the conveying speed and process time (ion implantation time) were changed to 0.2 m/min and 10 minutes, respectively, to thereby form a transparent conductive film of Example 11.

Example 12

The procedure of Example 11 was repeated, except that argon (Ar) was used as a plasma-generating gas, to thereby form a transparent conductive film of Example 12.

Example 13

The procedure of Example 2 was repeated, except that the applied voltage was adjusted to -5 kV, to thereby form a transparent conductive film of Example 13.

Example 14

The procedure of Example 2 was repeated, except that the pulse width was adjusted to 10 μsec, to thereby form a transparent conductive film of Example 14.

Example 15

The procedure of Example 1 was repeated, except that ion implantation conditions were changed to the following conditions, to thereby form a transparent conductive film of Example 15.

Ion implantation conditions

- Plasma-generating gas : Ar
- Duty ratio: 1%
- repetition frequency: 1,000 Hz
- Applied voltage : -15 kV
- RF power source: frequency 13.56 MHz, applied power 1,000 W
- Chamber pressure: 0.2 Pa
- Pulse width: 10 μsec
- Process time (ion implantation time): 1 min
- Conveying speed: 2 m/min

Example 16

The procedure of Example 11 was repeated, except that helium was used as a plasma-generating gas, to thereby form a transparent conductive film of Example 16.

Example 17

A platinum-containing catalyst (SRX-212, product of Dow Corning Toray) (2 parts by mass) was added to

addition-type silicone resin (predominant components: hexenyl group-containing polydimethylsiloxane and a cross-linking agent (polymethylhydrogensiloxane), LTC-760A, product of Dow Corning Toray) (100 parts by weight). To the mixture, acetophenone (photo-sensitizer) (1 part by mass with respect to the addition-type silicone resin) was added, and the resultant mixture was diluted with toluene to a solid content of 1 mass%. The thus-prepared liquid was uniformly applied, by means of a Mayer bar, onto a PEN film as employed in Example 1 to a coating thickness of 100 nm. The coated substrate was treated by means of a hot-blow recirculation drier at 50°C for 30 seconds. Immediately thereafter, the layer was irradiated with UV by means of a conveyer-type UV radiator (equipped with single lamp (fusion H bulb, 240 W/cm)) at a conveying speed of 40 m/min, to thereby form a layer containing polydimethylsiloxane. In a manner similar to that of Example 2, ions were implanted to the polydimethylsiloxane layer, to form a gas barrier layer. Then, a transparent conductive layer was formed on the ion-implanted layer in a manner similar to that of Example 1, to thereby produce a transparent conductive film of Example 17.

Before performing plasma ion implantation, the gas barrier layer was found to have a water vapor permeability of 16 (g/m$^2$/day) .

Example 18

Phenyltrimethoxysilane (product of Tokyo Kasei Kogyo Co., Ltd.) (3.97 g (20 mmol)), 3-glycidoxypropyltrimethoxysilane (product of Tokyo Kasei Kogyo Co., Ltd.) (4.73 g (20 mmol)), toluene (20 mL), distilled water (10 mL), and phosphoric acid (product of Kanto Kagaku) (0.10 g (1 mmol)) were mixed, and the mixture was allowed to react at room temperature for 24 hours. After completion of reaction, aqueous saturated sodium hydrogencarbonate was added to the reaction mixture. Ethyl acetate (100 mL) was added thereto for phase separation, and the organic layer was removed. The organic layer was washed twice with distilled water and dried over magnesium sulfate anhydrate, followed by filtering off magnesium sulfate. The thus-obtained filtrate was added dropwise to a large amount of n-hexane, to thereby precipitate a product. n-Hexane was separated through decantation, and the precipitated product was dissolved in THF, to thereby recover the product. Tetrahydrofuran (THF) was removed under reduced pressure by means of an evaporator, and the solid was dried in vacuum, to thereby yield polysilsesquioxane (polyorganosiloxane compound) having a ladder structure. The weight average molecular weight of the polymer was found to be 1,800. The polysilsesquioxane was dissolved in toluene, and the solution (solid content: 20 mass%) was applied onto a PEN film by means of a Mayer bar as employed in Example 1, and the coated substrate was heated at 125°C for 6 hours, to thereby form a polysilsesquioxane layer having a thickness of 10 μm. In a manner similar to that of Example 12, argon ions were implanted by means of a plasma ion implantation apparatus to the surface of the cured polysilsesquioxane layer, to thereby form a gas barrier layer. Then, a transparent conductive layer was formed in a manner similar to that of Example 1, to thereby produce a transparent conductive film of Example 18.

Before performing plasma ion implantation, the gas barrier layer was found to have a water vapor permeability of 12 (g/m$^2$/day) .

Example 19

The surface of the layer containing polydimethylsiloxane included in the molded product of Example 1 was subjected to a plasma treatment under the following conditions, instead of plasma ion implantation, to thereby form a transparent conductive film of Example 19.

- plasma treatment apparatus: plasma dry washer, model PDC-210, product of Yamato Material
- High-frequency electric power: 300 W
- High-frequency oscillating frequency: 13.56 MHz
- Plasma-generating gas: argon
- Gas flow rate: 50 mL/min
- Process pressure: 30 Pa
- process temperature: 40°C
- Process time: 3 minutes

Comparative Example 1

The procedure of Example 1 was repeated, except that ion implantation was not performed, to thereby form a transparent conductive film of Comparative Example 1. Specifically, a polydimethylsiloxane layer was formed on the PEN film, and a transparent conductive layer was formed on the substrate which had not been subjected to ion implantation.

Comparative Example 2

The procedure of Example 1 was repeated, except that silicone releasing agent A was not applied to a PEN film, to thereby form a transparent conductive film of Comparative Example 2. Specifically, nitrogen ions were implanted to an easy-adhesion surface of the PEN film through plasma ion implantation, and a transparent conductive layer was formed, to thereby form a transparent conductive film of Comparative Example 2.

FIGs. 4 to 14 are graphs each showing the oxygen atom concentration, carbon atom concentration, and silicon atom concentration (%) profiles of the gas barrier layer (ion-implanted polydimethylsiloxane layer) or the non-ion-implanted polydimethylsiloxane layer of Examples 1 to 10 and Comparative Example 1. The concentration profiles were obtained through elemental analysis based on XPS.

In each of FIGs. 4 to 14, the vertical axis represents each atom fraction (%) which calculated with respect to the sum of the fraction of of the oxygen atoms, carbon atoms, and silicon atoms (i.e., makes the sum of the fraction of the oxygen atoms, carbon atoms, and silicon atoms into 100%), and the horizontal axis represents elapsed sputtering time (sputter time, minutes). Since the sputtering rate was constant, the elapsed sputtering time (sputter time) corresponds to the sputtering depth. In FIGs. 4 to 14, a denotes the carbon atom fraction, b denotes the oxygen atom fraction, and c denotes the silicon atom fraction.

As shown in FIGs. 4 to 13, the ion-implanted polydimethylsiloxane layers of Examples 1 to 10 were found to have a region in which the oxygen atom concentration gradually decreased and the carbon atom concentration gradually increased from the surface in the depth direction. Also, the ion-implanted polydimethylsiloxane layers of Examples 11 to 18 and the plasma-treated (not ion-implanted) polydimethylsiloxane layer of Example 19 were found to have a region in which the oxygen atom concentration gradually decreased and the carbon atom concentration gradually increased from the surface in the depth direction.

In contrast, as shown in FIG. 14, the non-ion-implanted polydimethylsiloxane layer of Comparative Example 1 was found to have no such region.

Table 1 shows the oxygen atom fraction, carbon atom fraction, and silicon atom fraction (%) of the surface layer part of the gas barrier layer as well as the silicon atom 2p electron binding energy peak of each of the transparent conductive films of Examples 1 to 10, Example 19, and Comparative Example 1. In the transparent conductive films of Examples 1 to 10 and Example 19, the surface layer part of the gas barrier layer is a plasma ion-implanted surface or a plasma-treated surface. The measurements of the plasma ion-implanted surface or plasma-treated surface obtained through the aforementioned methods represent the oxygen atom fraction, carbon atom fraction, and silicon atom fraction and the silicon atom 2p electron binding energy peak of the surface layer part of the gas barrier layer.

[Table 1]

| Plasma ion-implanted or plasma-treated polydimethylsiloxane surface | Atom fraction (%) | | | Si atom 2p electron binding energy peak (eV) |
|---|---|---|---|---|
| | O atom | C atom | Si atom | |
| Ex. 1 | 59.6 | 17.5 | 22.9 | 103.0 |
| Ex. 2 | 49.7 | 27.4 | 22.9 | 103.3 |
| Ex. 3 | 52.9 | 26.5 | 20.6 | 103.1 |
| Ex. 4 | 60.3 | 15.3 | 24.4 | 103.1 |
| Ex. 5 | 54.5 | 24.3 | 21.2 | 103.1 |
| Ex. 6 | 44.0 | 37.4 | 18.6 | 103.0 |
| Ex. 7 | 58.1 | 19.3 | 22.6 | 103.0 |
| Ex. 8 | 46.3 | 35.4 | 18.3 | 103.0 |
| Ex. 9 | 46.0 | 38.8 | 15.2 | 102.9 |
| Ex. 10 | 30.8 | 58.9 | 10.3 | 102.9 |
| Ex. 19 | 63.3 | 11.2 | 25.5 | 103.3 |
| Comp. Ex. 1 | 29.9 | 54.1 | 16.0 | 101.5 |

As is clear from Table 1, the silicon atom 2p electron binding energy peaks of the transparent conductive films of Examples 1 to 10 and 19 were 102.9 eV to 103.3 eV.

The transparent conductive film produced in Example 2 was analyzed through XPS, to thereby provide a silicon atom 2p electron binding energy profile. The results are shown in FIG. 15. In FIG. 15, the vertical axis denotes peak intensity, and the horizontal axis denotes binding energy (eV). As is clear from FIG. 15, the silicon atom 2p electron binding energy peak of the transparent conductive film produced in Example 2 was found to be 103.3 eV (B). Before ion implantation, the silicon atom 2p electron binding energy peak of the transparent conductive film (A, Comparative Example 1) was 101.5 eV, which was shifted to the higher energy side; i.e., 103.3 eV after ion implantation.

Next, the water vapor permeability and total luminous transmittance of each of the transparent conductive films produced in Examples 1 to 19 and Comparative Examples 1 and 2 were determined by means of a water vapor permeability measurement apparatus and a total luminous transmittance measurement apparatus. The results are shown in Table 2.

[Table 2]

| Film before formation of transparent conductive film | Water vapor permeability ($g/m^2/day$) | Total luminous transmittance (%) |
|---|---|---|
| Ex. 1 | 0.4 | 78.1 |
| Ex. 2 | 0.3 | 79.0 |
| Ex. 3 | 1.2 | 78.1 |
| Ex. 4 | 0.89 | 79.0 |
| Ex. 5 | 1.1 | 78.2 |
| Ex. 6 | 0.78 | 79.0 |
| Ex. 7 | 0.12 | 78.7 |
| Ex. 8 | 0.14 | 78.6 |
| Ex. 9 | 0.34 | 79.6 |
| Ex. 10 | 0.44 | 78.7 |
| Ex. 11 | 0.89 | 78.7 |
| Ex. 12 | 0.3 | 78.5 |
| Ex. 13 | 0.77 | 78.5 |
| Ex. 14 | 0.31 | 78.6 |
| Ex. 15 | 0.46 | 79.0 |
| Ex. 16 | 0.36 | 78.9 |
| Ex. 17 | 0.82 | 79.2 |
| Ex. 18 | 0.88 | 78.9 |
| Ex. 19 | 0.94 | 78.0 |
| Comp. Ex. 1 | 5.35 | 78.1 |
| Comp. Ex. 2 | 6.7 | 78.3 |

As is clear from Table 2, the transparent conductive films of Examples 1 to 19 exhibited low water vapor permeability, as compared with the those of Comparative Examples 1 and 2, and therefore, were found to have excellent gas barrier performance. Also, the transparent conductive films of Examples 1 to 19 exhibited high total luminous transmittance values, which were not virtually lowered after ion implantation.

Next, the sheet resistivity and moisture- and heat-resistance test results of the transparent conductive films of the Examples and Comparative Examples are shown in Table 3.

[Table 3]

| | Sheet resistivity (Ω/squire) | | | | |
|---|---|---|---|---|---|
| | Initial: $R_0$ | 60°C, 3 days: $R_1$ | T1 =($R_1$-$R_0$)/ $R_0$ | 60°C-90%RH, 3 days: $R_2$ | T2=($R_2$-$R_0$)/$R_0$ |
| Ex. 1 | 480 | 500 | 0.04 | 750 | 0.56 |
| Ex. 2 | 490 | 490 | 0.00 | 620 | 0.27 |
| Ex. 3 | 500 | 500 | 0.00 | 600 | 0.20 |
| Ex. 4 | 490 | 510 | 0.04 | 660 | 0.35 |
| Ex. 5 | 480 | 510 | 0.06 | 590 | 0.23 |
| Ex. 6 | 490 | 520 | 0.06 | 640 | 0.31 |
| Ex. 7 | 510 | 510 | 0.00 | 620 | 0.22 |
| Ex. 8 | 490 | 500 | 0.02 | 700 | 0.43 |
| Ex. 9 | 490 | 510 | 0.04 | 710 | 0.45 |
| Ex. 10 | 500 | 510 | 0.02 | 620 | 0.24 |
| Ex. 11 | 490 | 500 | 0.02 | 600 | 0.22 |
| Ex. 12 | 510 | 520 | 0.02 | 650 | 0.27 |
| Ex. 13 | 500 | 500 | 0.00 | 620 | 0.24 |
| Ex. 14 | 500 | 520 | 0.04 | 630 | 0.26 |
| Ex. 15 | 500 | 505 | 0.01 | 660 | 0.32 |
| Ex. 16 | 510 | 520 | 0.02 | 700 | 0.37 |
| Ex. 17 | 500 | 520 | 0.04 | 720 | 0.44 |
| Ex. 18 | 520 | 520 | 0.00 | 690 | 0.33 |
| Ex. 19 | 480 | 510 | 0.06 | 680 | 0.42 |
| Comp. Ex. 1 | 480 | 1200 | 1.50 | 280000 | 582.33 |
| Comp. Ex. 2 | 500 | 2400 | 3.80 | 470000 | 939.00 |

Industrial Applicability

The transparent conductive film of the present invention is suitably employed as a flexible display member or an electronic device member such as a solar battery back sheet.

According to the production method of the present invention, transparent conductive film products having excellent gas barrier performance and falling within the scope of the present invention can be produced with safety in a simple manner.

By virtue of excellent as barrier performance and transparency, the transparent conductive film of the present invention is suitably used in a display or an electronic device such as a solar battery.

Description of Reference Numerals

1a, 1c···film 1b, 1d···film having gas barrier layer, 2a, 2b···high-voltage application rotatable can, 3a, 3b···unwinding roller, 4···plasma discharge electrode, 5a, 5b···winding roller, 6a, 6b···feed roller, 7a, 7b···high-voltage pulse power source, 9a, 9b···high-voltage pulse, 10a, 10b···gas inlet, 11a, 11b···chamber, 13···center axis, 15···high-voltage-introduction terminal, 20a, 20b···oil diffusion pump, 100···transparent conductive film, 110···substrate, 120···gas barrier layer, 121···surface layer part of gas barrier layer, and 130···transparent conductive layer

## Claims

**1.** A transparent conductive film which is in the form of a zinc oxide-based electrically conductive stacked structure,

**characterized in that** the film comprises a substrate and, formed on at least one surface of the substrate, (A) a gas barrier layer and (B) a transparent conductive layer formed of a zinc oxide-based conductive material, wherein the gas barrier layer is formed of a material containing at least oxygen atoms, carbon atoms, and silicon atoms, and includes a region in which the oxygen atom concentration gradually decreases and the carbon atom concentration gradually increases from the surface in the depth direction of the layer.

**2.** A transparent conductive film according to claim 1, wherein the surface layer part of the gas barrier layer has an oxygen atom fraction of 10 to 70%, a carbon atom fraction of 10 to 70%, and a silicon atom fraction of 5 to 35%, each atom fraction being calculated with respect to the total number of the oxygen atoms, carbon atoms, and silicon atoms contained in the gas barrier layer.

**3.** A transparent conductive film according to claim 1 or 2, wherein the gas barrier layer exhibits a silicon atom 2p electron binding energy peak at 102 to 104 eV, as measured through X-ray photoelectron spectrometry (XPS) of the surface layer part thereof.

**4.** A transparent conductive film according to any of claims 1 to 3, wherein the gas barrier layer contains a polyorganosiloxane compound.

**5.** A transparent conductive film according to claim 4, wherein the polyorganosiloxane compound is a polyorganosiloxane represented by the following formula (a):

[F1]

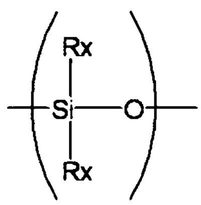

(a)

or formula (b):

[F2]

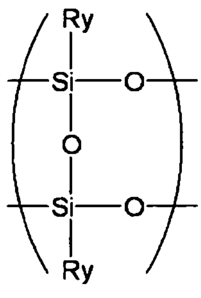

(b)

(wherein Rx and Ry each represent a non-hydrolyzable group such as a hydrogen atom, a substituted or unsubstituted alkyl group, a substituted or unsubstituted alkenyl group, or a substituted or unsubstituted aryl group; a plurality of Rxs in formula (a) may be identical to or different from one another; and a plurality of Rys in formula (b) may be identical to or different from one another, excluding the case where the two Rxs in formula (a) are hydrogen atoms).

**6.** A transparent conductive film according to any of claims 1 to 5, wherein the gas barrier layer has a thickness of 30 nm to 10 μm, and the surface layer part of the gas barrier layer has a thickness of 5 nm to 100 nm.

**7.** A transparent conductive film according to any of claims 1 to 6, wherein the gas barrier layer is formed through ion

implantation into a layer containing a polyorganosiloxane compound.

8. A transparent conductive film according to claim 7, wherein ion implantation is performed to a surface layer part of the layer containing a polyorganosiloxane compound.

9. A transparent conductive film according to claim 7 or 8, wherein the ion is an ionic species formed through ionization of at least one gas selected from the group consisting of hydrogen, nitrogen, oxygen, a rare gas, and a fluorocarbon.

10. A transparent conductive film according to any one of claims 7 to 9, wherein ion implantation is performed through plasma ion implantation.

11. A transparent conductive film according to any one of claims 1 to 10, wherein the transparent conductive layer has a thickness of 20 to 500 nm, and the transparent conductive film has a sheet resistivity of 1,000 Ω/square or less.

12. A transparent conductive film according to any one of claims 1 to 11, wherein the zinc oxide-based conductive material contains at least one element selected from among gallium, indium, and silicon, in an amount of 0.01 to 10 mass%.

13. A transparent conductive film according to any of claims 1 to 12, wherein the transparent conductive film exhibits a change ratio in sheet resistivity represented by $T_1=(R_1-R_0)/R_0$ of 1.0 or less and a change ratio in sheet resistivity represented by $T_2=(R_2-R_0)/R_0$ of 1.0 or less, wherein $R_0$ represents an initial sheet resistivity, $R_1$ represents a sheet resistivity after the film has been placed under a 60°C-90% RH condition for three days, and $R_2$ represents a sheet resistivity after the film has been placed under a 60°C condition for three days.

14. A method for producing a transparent conductive film, **characterized in that** the method comprises a step of performing ion implantation into a layer containing a polyorganosiloxane compound, to thereby form a gas barrier layer, and a step of forming, on the gas barrier layer, a transparent conductive layer formed of a zinc oxide-based conductive material.

15. A method for producing a transparent conductive film according to claim 14, wherein the ion implantation step includes ionization of at least one gas selected from the group consisting of hydrogen, nitrogen, oxygen, a rare gas, and a fluorocarbon, and implantation of the formed ion species.

16. A method for producing a transparent conductive film according to claim 15, wherein the ion implantation step is performed through plasma ion implantation.

17. A method for producing a transparent conductive film according to claim 15 or 16, wherein the ion implantation step includes performing ion implantation into a layer containing a polyorganosiloxane compound while the layer containing a polyorganosiloxane compound in the form of elongated film is conveyed in a specific direction.

18. An electronic device employing a transparent conductive film as recited in any one of claims 1 to 13.

FIG. 1

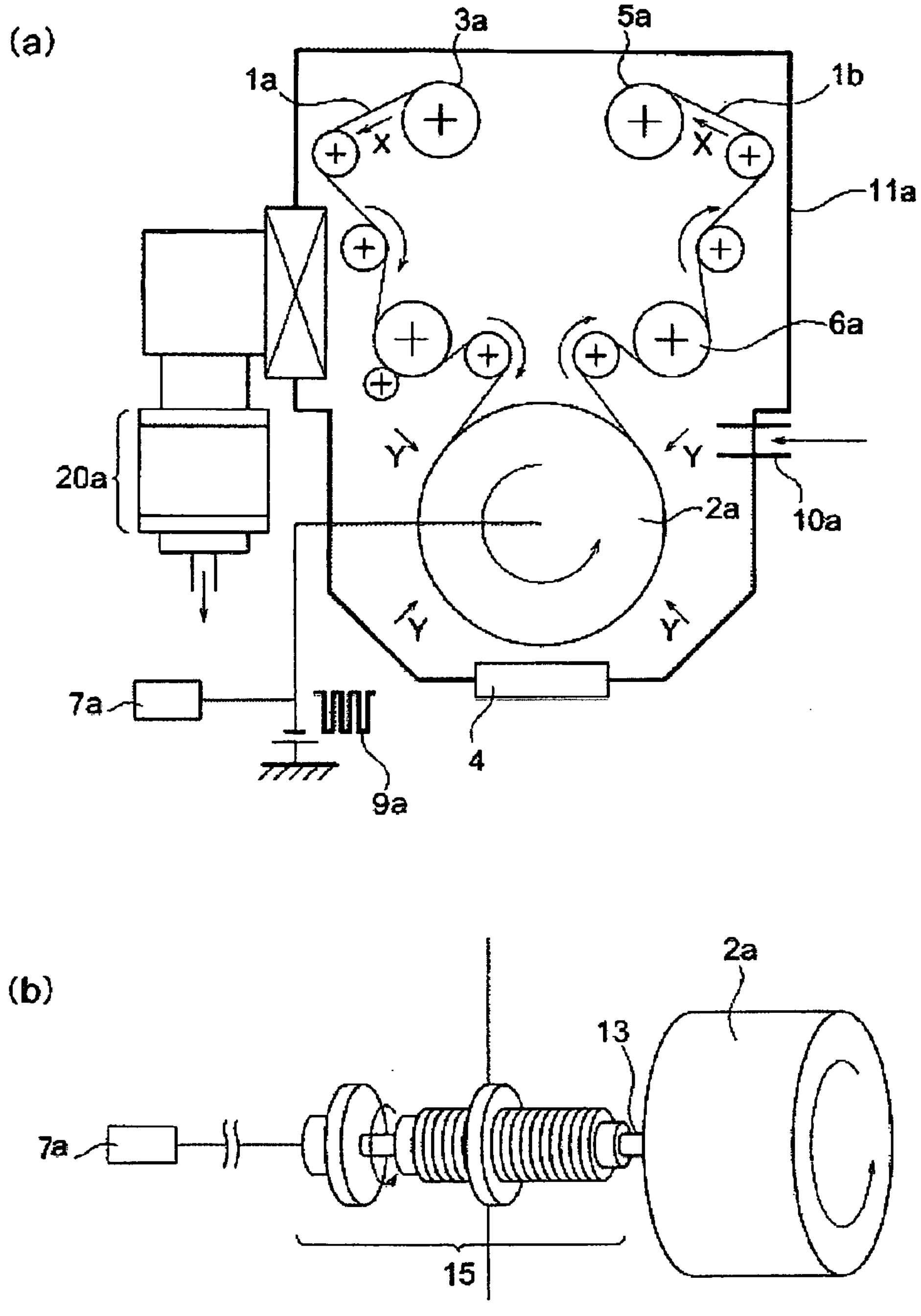

FIG. 2

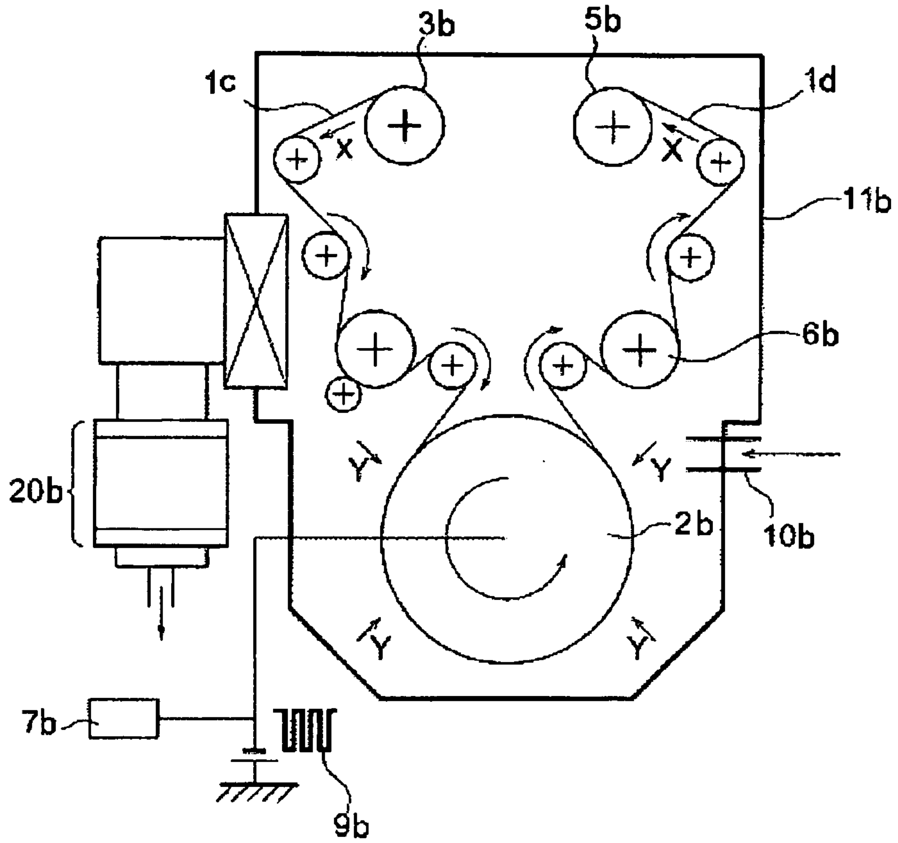


FIG. 3

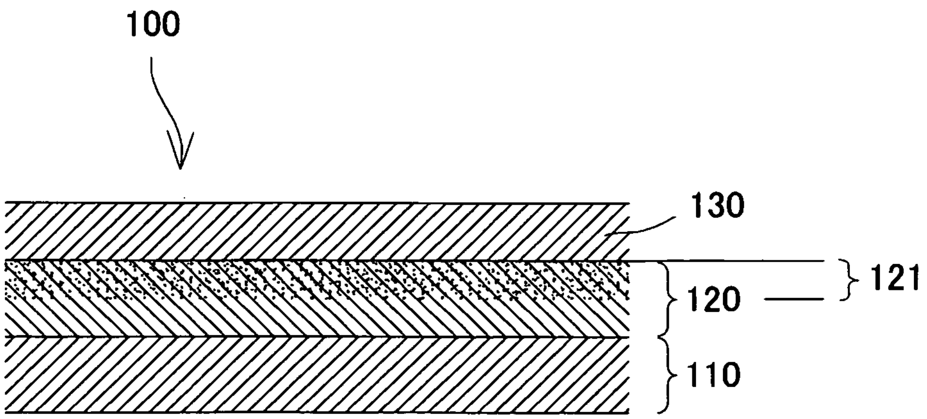

FIG. 4

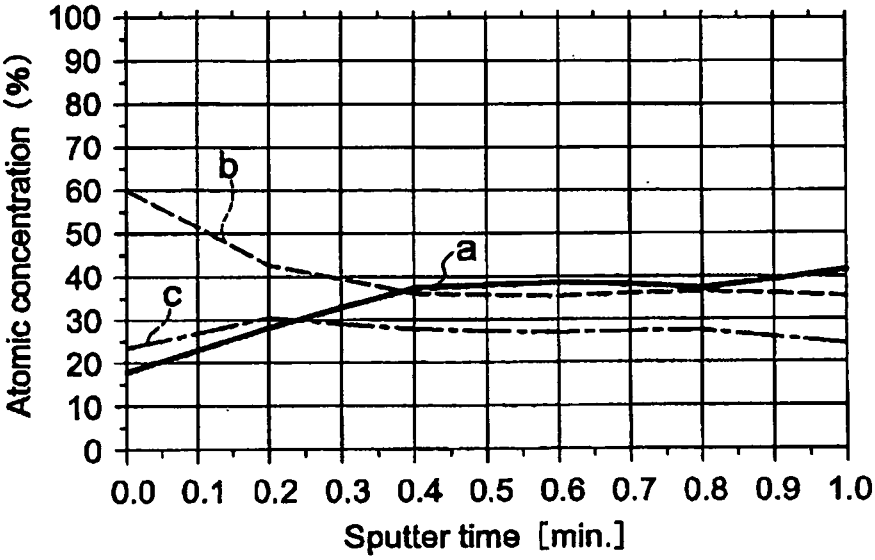
Atomic concentration (%)
100
90
80
70
60
50
40
30
20
10
0
a
b
c
0.0 0.1 0.2 0.3 0.4 0.5 0.6 0.7 0.8 0.9 1.0
Sputter time [min.]

FIG. 5

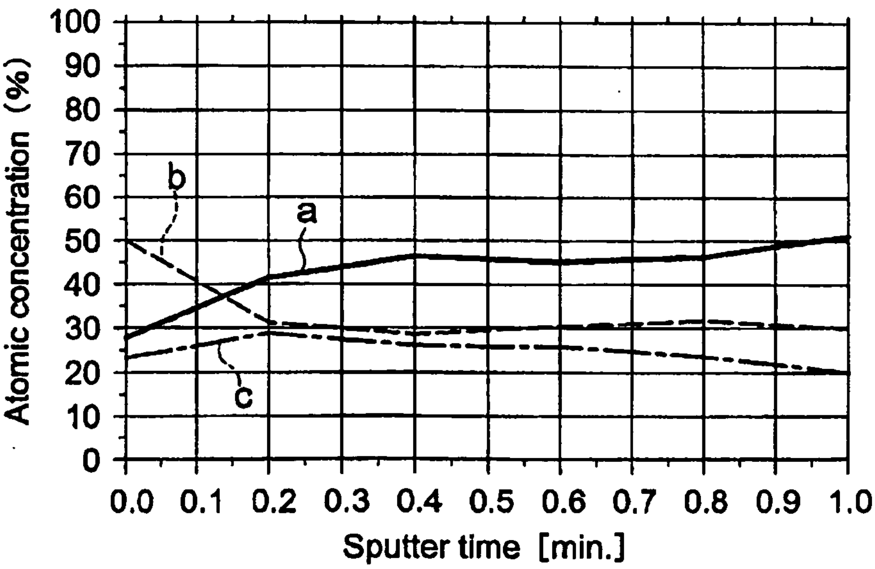
Atomic concentration (%)
100
90
80
70
60
50
40
30
20
10
0
a
b
c
0.0 0.1 0.2 0.3 0.4 0.5 0.6 0.7 0.8 0.9 1.0
Sputter time [min.]

FIG. 6

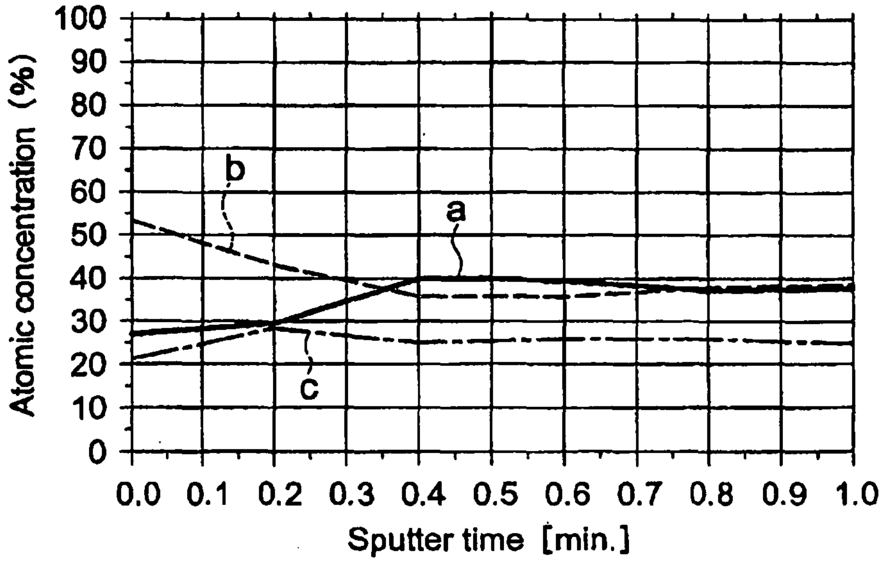
100
90
80
70
60
50
40
30
20
10
0
Atomic concentration (%)
a
b
c
0.0 0.1 0.2 0.3 0.4 0.5 0.6 0.7 0.8 0.9 1.0
Sputter time [min.]

FIG. 7

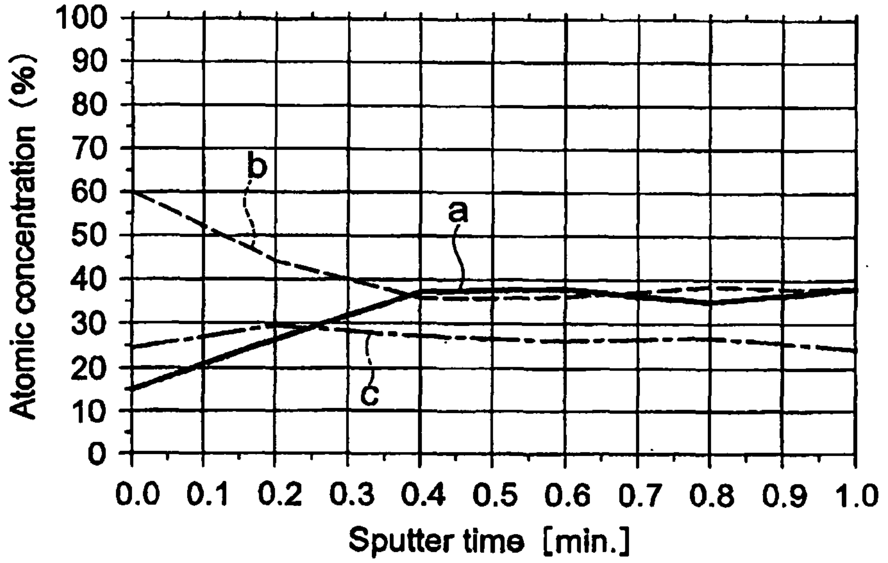
100
90
80
70
60
50
40
30
20
10
0
Atomic concentration (%)
a
b
c
0.0 0.1 0.2 0.3 0.4 0.5 0.6 0.7 0.8 0.9 1.0
Sputter time [min.]

FIG. 8

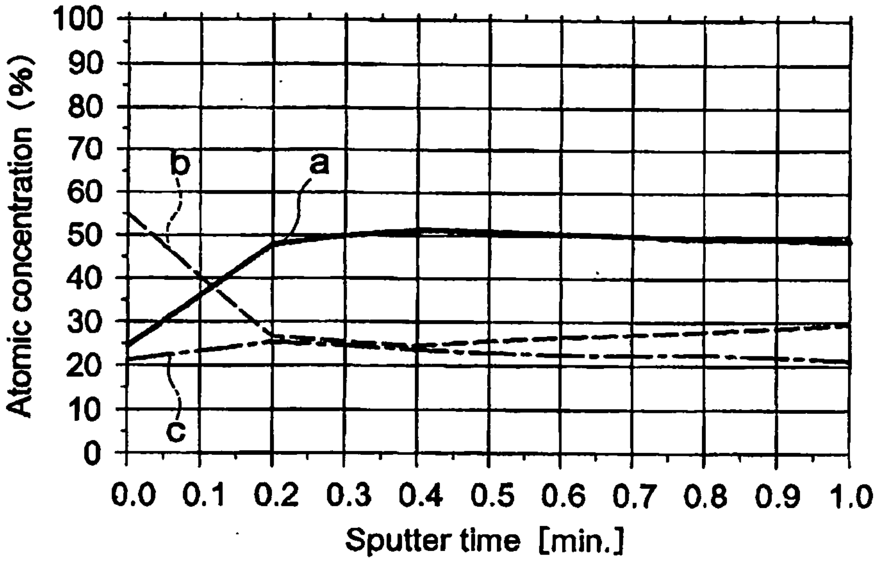
100
90
80
70
60
50
40
30
20
10
0
Atomic concentration (%)
a
b
c
0.0 0.1 0.2 0.3 0.4 0.5 0.6 0.7 0.8 0.9 1.0
Sputter time [min.]

FIG. 9

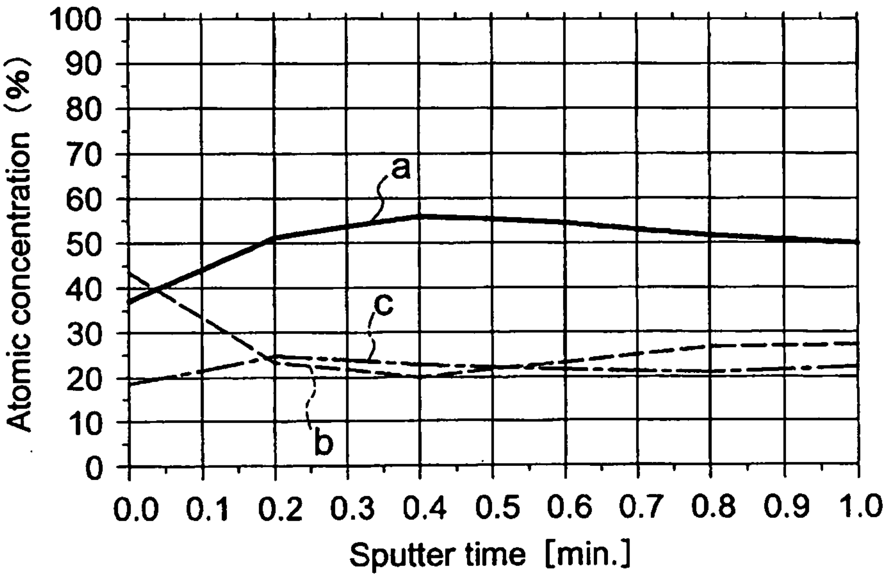
100
90
80
70
60
50
40
30
20
10
0
Atomic concentration (%)
a
b
c
0.0 0.1 0.2 0.3 0.4 0.5 0.6 0.7 0.8 0.9 1.0
Sputter time [min.]

FIG. 10

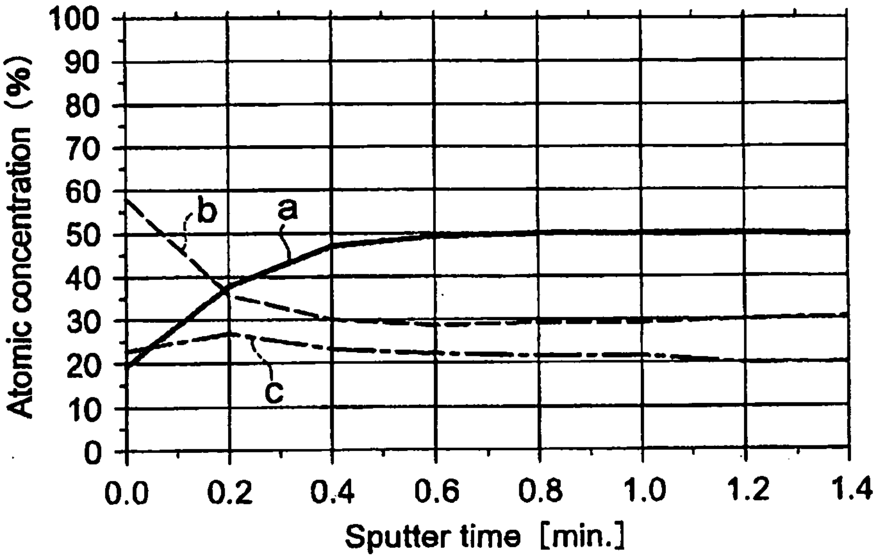
100
90
80
70
60
50
40
30
20
10
0
Atomic concentration (%)
b
a
c
0.0
0.2
0.4
0.6
0.8
1.0
1.2
1.4
Sputter time [min.]

FIG. 11

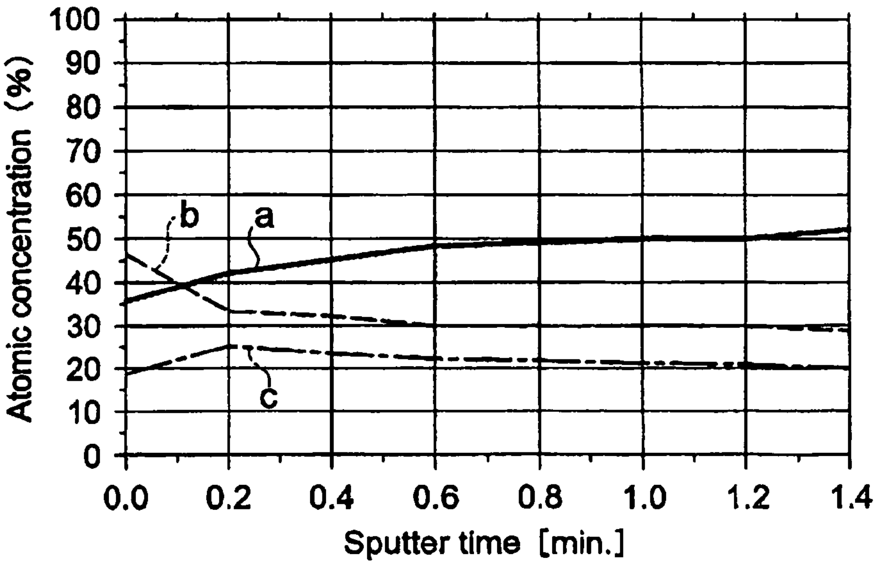
100
90
80
70
60
50
40
30
20
10
0
Atomic concentration (%)
b
a
c
0.0
0.2
0.4
0.6
0.8
1.0
1.2
1.4
Sputter time [min.]

FIG. 12

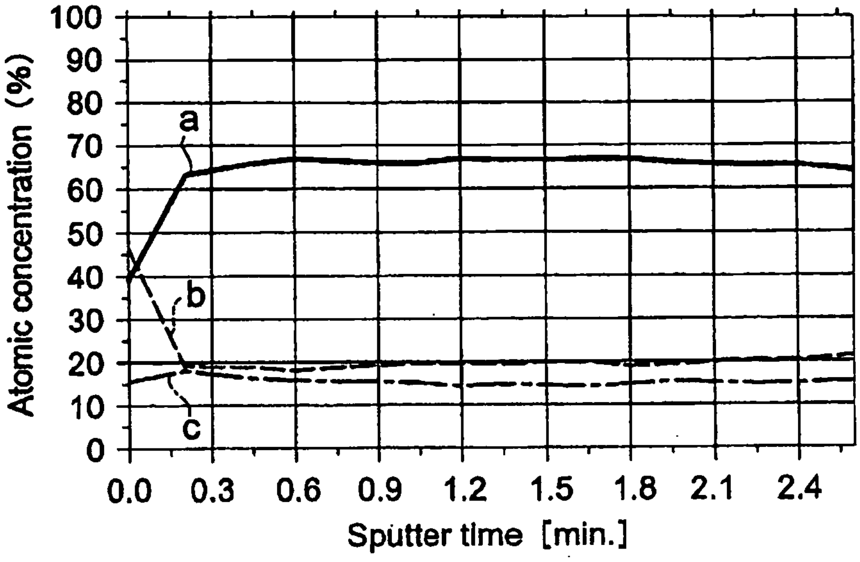
100
90
80
70
60
50
40
30
20
10
0
Atomic concentration (%)
a
b
c
0.0
0.3
0.6
0.9
1.2
1.5
1.8
2.1
2.4
Sputter time [min.]

FIG. 13

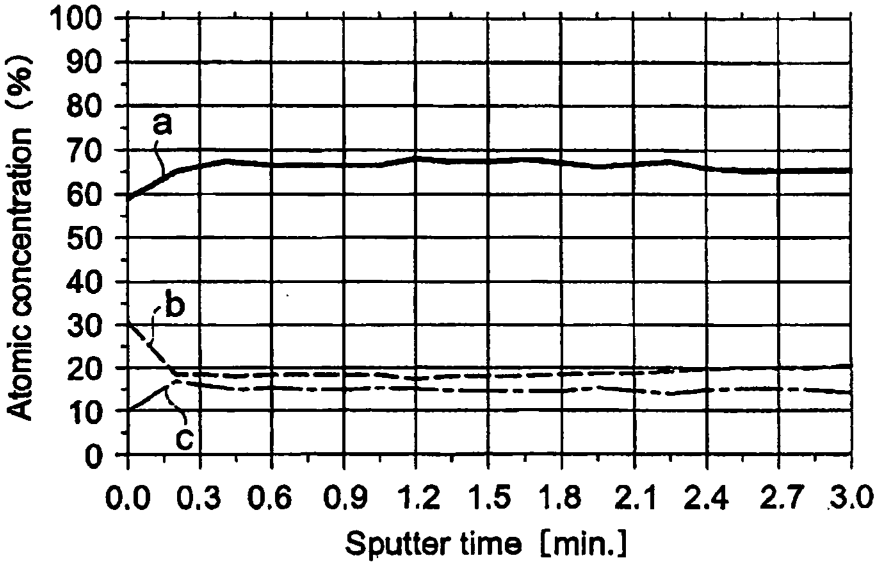
100
90
80
70
60
50
40
30
20
10
0
Atomic concentration (%)
a
b
c
0.0
0.3
0.6
0.9
1.2
1.5
1.8
2.1
2.4
2.7
3.0
Sputter time [min.]

FIG. 14

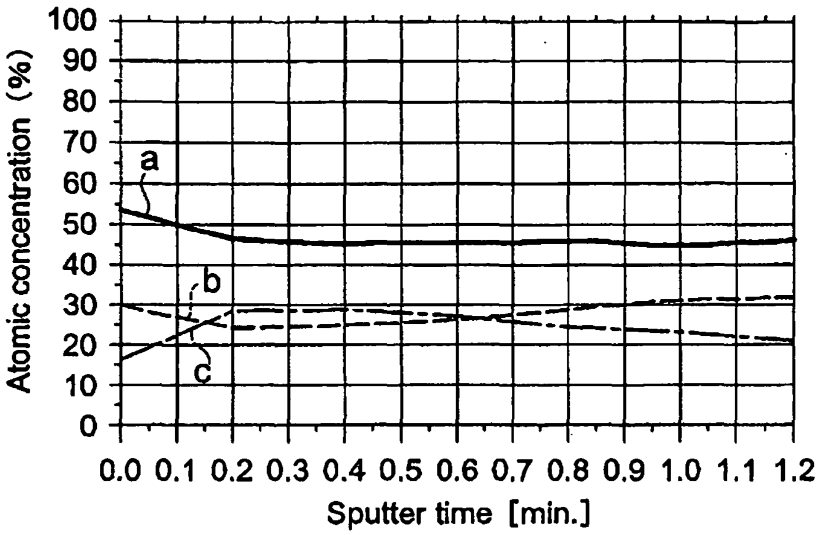
100
90
80
70
60
50
40
30
20
10
0
Atomic concentration (%)
a
b
c
0.0 0.1 0.2 0.3 0.4 0.5 0.6 0.7 0.8 0.9 1.0 1.1 1.2
Sputter time [min.]

FIG. 15

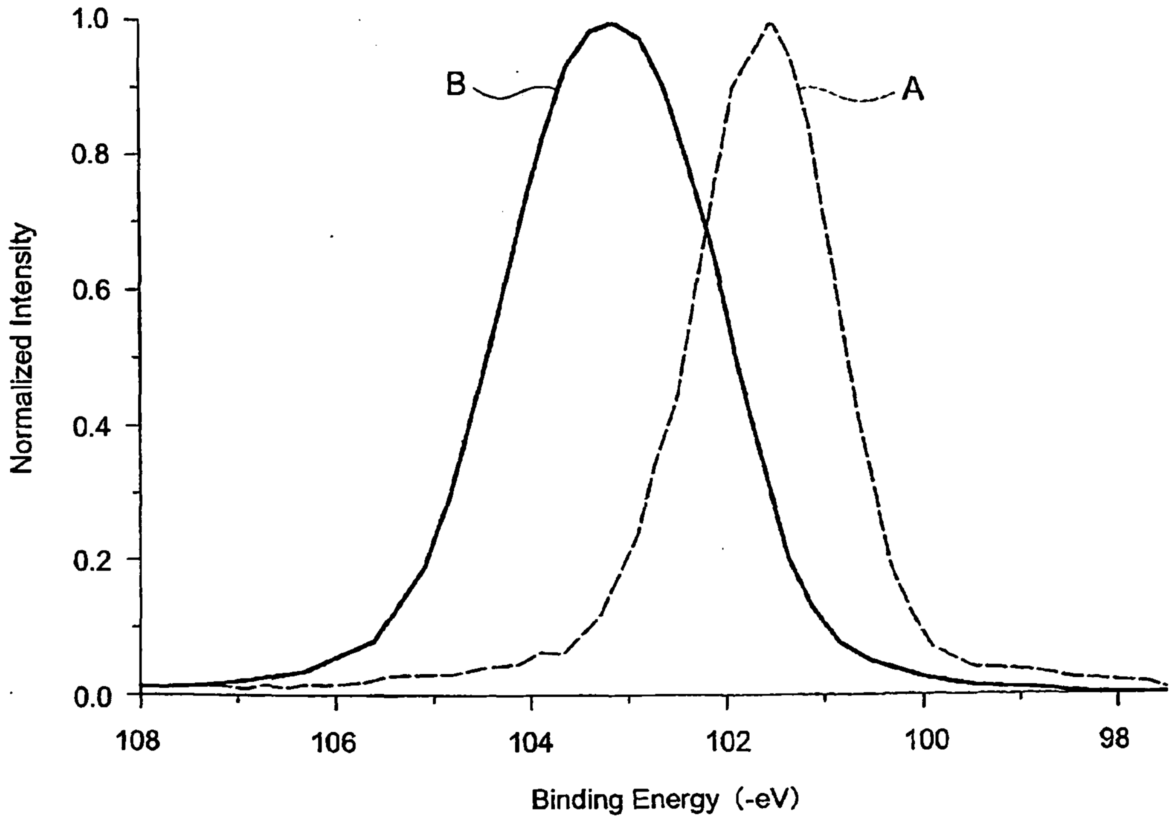
1.0
0.8
0.6
0.4
0.2
0.0
Normalized Intensity
B
A
108
106
104
102
100
98
Binding Energy (-eV)

**INTERNATIONAL SEARCH REPORT**

International application No. PCT/JP2011/051507

A. CLASSIFICATION OF SUBJECT MATTER

*H01B5/14*(2006.01)i, *B32B9/00*(2006.01)i, *C23C14/08*(2006.01)i, *C23C14/48*(2006.01)i, *H01B13/00*(2006.01)i

According to International Patent Classification (IPC) or to both national classification and IPC

B. FIELDS SEARCHED

Minimum documentation searched (classification system followed by classification symbols)

H01B5/14, B32B9/00, C23C14/08, C23C14/48, H01B13/00

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2008-270115 A (Toppan Printing Co., Ltd.), 06 November 2008 (06.11.2008), entire text (Family: none) | 1-18 |
| P,X | JP 2011-000718 A (Lintec Corp.), 06 January 2011 (06.01.2011), entire text (Family: none) | 1-18 |
| P,X | WO 2010/134609 A1 (Lintec Corp.), 25 November 2010 (25.11.2010), entire text (Family: none) | 1-18 |

☒ Further documents are listed in the continuation of Box C.  ☐ See patent family annex.

* Special categories of cited documents:

"A" document defining the general state of the art which is not considered to be of particular relevance

"E" earlier application or patent but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step when the document is taken alone

"Y" document of particular relevance; the claimed invention cannot be considered to involve an inventive step when the document is combined with one or more other such documents, such combination being obvious to a person skilled in the art

"&" document member of the same patent family

| | |
|---|---|
| Date of the actual completion of the international search<br>21 April, 2011 (21.04.11) | Date of mailing of the international search report<br>10 May, 2011 (10.05.11) |
| Name and mailing address of the ISA/<br>Japanese Patent Office<br>Facsimile No. | Authorized officer<br><br>Telephone No. |

Form PCT/ISA/210 (second sheet) (July 2009)

**INTERNATIONAL SEARCH REPORT**

International application No.
PCT/JP2011/051507

C (Continuation). DOCUMENTS CONSIDERED TO BE RELEVANT

| Category* | Citation of document, with indication, where appropriate, of the relevant passages | Relevant to claim No. |
|---|---|---|
| P,X | WO 2010/134611 A1 (Lintec Corp.), 25 November 2010 (25.11.2010), entire text (Family: none) | 1-18 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2000338901 A
- JP 2006123307 A
- JP HEI845452 B
- JP HEI6187833 B
- JP 2009199812 A
- JP 2009110897 A
- JP 2001026887 A
- JP 2001156013 A


### Non-patent literature cited in the description


- *APPLIED PHYSICS LETTERS,* 2006, vol. 89, 091904